(19) Europäisches Patentamt
European Patent Office
Office européen des brevets

(11) **EP 1 724 317 B1**

(12) **EUROPEAN PATENT SPECIFICATION**

(45) Date of publication and mention of the grant of the patent:
**22.10.2008 Bulletin 2008/43**

(51) Int Cl.:
*C09G 1/02* *(2006.01)*     *C09K 3/14* *(2006.01)*
*H01L 21/321* *(2006.01)*

(21) Application number: **06113995.2**

(22) Date of filing: **16.05.2006**

(54) **Chemical mechanical polishing aqueous dispersion, chemical mechanical polishing method, and kit for preparing chemical mechanical polishing aqueous dispersion**

Wässrige Dispersion für chemisch-mechanisches Polieren, chemisch-mechanisches Polierverfahren und Kit zur Zubereitung einer wässrigen Dispersion für chemisch-mechanisches Polieren

Dispersion aqueuse par polissage chimico-mécanique, méthode de polissage chimico-mécanique et kit de préparation de la dispersion aqueuse par polissage chimico-mécanique

(84) Designated Contracting States:
**DE FR GB IT**

(30) Priority: **17.05.2005 JP 2005143580**

(43) Date of publication of application:
**22.11.2006 Bulletin 2006/47**

(73) Proprietor: **JSR Corporation**
**Tokyo 104-8410 (JP)**

(72) Inventors:
• **Uchikura, Kazuhito**
**Tokyo**
**Tokyo 104-8410 (JP)**
• **Konno, Tomohisa**
**Tokyo**
**Tokyo 104-8410 (JP)**
• **Kawahashi, Nobuo**
**Tokyo**
**Tokyo 104-8410 (JP)**
• **Hattori, Masayuki**
**Aichi-ken 498-0026 (JP)**

(74) Representative: **TBK-Patent**
**Bavariaring 4-6**
**80336 München (DE)**

(56) References cited:
**EP-A- 1 116 762**     **EP-A- 1 386 949**
**EP-A- 1 586 614**     **US-A1- 2002 173 241**
**US-A1- 2005 037 693**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a chemical mechanical polishing aqueous dispersion, a chemical mechanical polishing method, and a kit for preparing the chemical mechanical polishing aqueous dispersion.

More particularly, the invention relates to a chemical mechanical polishing aqueous dispersion used in the manufacture of semiconductor devices which is capable of efficiently chemically and mechanically polishing each polishing target material provided on a semiconductor substrate and forming a sufficiently planarized and accurately finished surface, a chemical mechanical polishing method using the chemical mechanical polishing aqueous dispersion, and a kit for preparing the chemical mechanical polishing aqueous dispersion.

In recent years, interconnects formed in semiconductor devices have been increasingly scaled down along with an increase in the degree of integration of semiconductor devices. A damascene method is known as technology capable of scaling down the interconnects. In the damascene method, a groove formed in an insulating material is filled with an interconnect material, and unnecessary interconnect material deposited in an area other than the groove is removed by chemical mechanical polishing to form a desired interconnect. When using copper or a copper alloy as the interconnect material, a barrier metal film is generally formed at the interface between copper or a copper alloy and the insulating material using tantalum, tantalum nitride, titanium nitride, or the like in order to prevent migration of copper atoms into the insulating material.

When using the damascene method in the manufacture of semiconductor devices using copper or a copper alloy as the interconnect material, chemical mechanical polishing is performed in various ways. In particular, two-stage chemical mechanical polishing is advantageously performed which includes a first polishing step of mainly removing copper or a copper alloy and a second polishing step of mainly removing the barrier metal film.

In the second polishing step, the insulating film exposed after removing the barrier metal is polished to a small extent in addition to removing the barrier metal in an area other than the interconnect area in order to obtain a highly planarized polished surface by repairing recess-shaped surface defects such as dishing or erosion which have occurred in the interconnect area in the first polishing step. In the interconnect area, copper or a copper alloy (interconnect material) and the barrier metal formed between the interconnect material and the insulating film are chemically and mechanically polished at the same time in addition to the insulating film.

In order to obtain a sufficiently planarized and accurately finished surface, it is desirable that a chemical mechanical polishing aqueous dispersion used in the second polishing step remove copper or a copper alloy, the barrier metal, and the insulating film at an equal removal rate.

In order to achieve this object, JP-A-2001-196336 discloses a chemical mechanical polishing aqueous dispersion containing abrasives, an oxidizing agent, and a specific polishing rate adjusting agent. The example of JP-A-2001-196336 discloses two-stage polishing using a chemical mechanical polishing aqueous dispersion having a ratio "$R_{Cu}/R_{BM}$" of the polishing rate $R_{Cu}$ of the copper film to the polishing rate $R_{BM}$ of the barrier metal film of 0.66 to 1.11 and a ratio "$R_{Cu}/R_{In}$" of the polishing rate $R_{Cn}$ of the copper film to the polishing rate $R_{In}$ of the insulating film of 0.72 to 1.42 in the second polishing step.

As the insulating film of semiconductor devices, a silicon oxide film formed by a vacuum process such as chemical vapor deposition (CVD) method has been widely used. The silicon oxide film formed by the vacuum process has a relatively high dielectric constant.

In recent years, an insulating film having a lower dielectric constant has been used in order to improve the performance of semiconductor devices, and semiconductor devices using a low-dielectric-constant insulating film material have been developed. As examples of the low-dielectric-constant insulating film material, an insulating film obtained by plasma polymerization of a silicon-containing compound, polysiloxane, polysilazane, polyarylene ether, polybenzoxazole, polyimide, silsesquioxane, and the like can be given.

However, such a low-dielectric-constant insulating film material has a low mechanical strength and is soft and brittle in comparison with a silicon oxide film formed by the vacuum process. Therefore, when chemical mechanical polishing is performed using a known chemical mechanical polishing aqueous dispersion when manufacturing semiconductor devices by the damascene method on a semiconductor substrate having an insulating film formed of such a material, scratches or peeling may occur on the semiconductor substrate (polishing target), whereby the yield of the product may be decreased.

SUMMARY

The invention may provide a chemical mechanical polishing aqueous dispersion which can efficiently polish various polishing targets, produce a sufficiently planarized and accurately finished surface, and prevent occurrence of scratches or peeling on a semiconductor substrate (polishing target) when chemically and mechanically polishing a semiconductor substrate having an insulating film formed of a low-dielectric-constant material exhibiting a low mechanical strength, a chemical mechanical polishing method using the chemical mechanical polishing aqueous dispersion, and a kit for preparing the chemical mechanical polishing aqueous dispersion.

According to a first aspect of the invention, there is provided a chemical mechanical polishing aqueous dispersion, comprising:

(A) inorganic particles;
(B) at least one type of particles selected from the group consisting of organic particles and organic-inorganic composite particles;
(C) at least one compound selected from the group consisting of quinolinecarboxylic acid, quinolinic acid, a divalent organic acid (excluding quinolinic acid), and a hydroxyl acid;
(D) at least one compound selected from the group consisting of benzotriazole and benzotriazole derivatives;
(E) an oxidizing agent; and
(F) water,
the chemical mechanical polishing aqueous dispersion containing the component (A) in an amount of 0.05 to 2.0 wt% and the component (B) in an amount of 0.005 to 1.5 wt% and the component (E) in an amount of 0.05 to 0.5 wt%, having a ratio ($W_A/W_B$) of the amount ($W_A$) of the component (A) to the amount ($W_B$) of the component (B) of 0.1 to 200, and having a pH of 1.0 to 5.0.

The chemical mechanical polishing aqueous dispersion may contain the component (C) in an amount of 0.005 to 3.0 wt%.

In this chemical mechanical polishing aqueous dispersion, the component (A) may be silica particles.

In this chemical mechanical polishing aqueous dispersion, the component (D) may be benzotriazole and may be contained in the chemical mechanical polishing aqueous dispersion in an amount of 0.01 to 5.0 wt%.

In this chemical mechanical polishing aqueous dispersion, the component (E) may be hydrogen peroxide.

According to a second aspect of the invention, there is provided a kit for preparing the above-described chemical mechanical polishing aqueous dispersion by mixing a liquid (I) and a liquid (II),
the liquid (I) being an aqueous dispersion including: the inorganic particles (A); at least one type of particles (B) selected from the group consisting of organic particles and organic-inorganic composite particles; at least one compound (C) selected from the group consisting of quinolinecarboxylic acid, quinolinic acid, a divalent organic acid (excluding quinolinic acid), and a hydroxyl acid; at least one compound (D) selected from the group consisting of benzotriazole and benzotriazole derivatives; and the water (F); and
the liquid (II) including the oxidizing agent (E) and the water (F).

According to a third aspect of the invention, there is provided a kit for preparing the above-described chemical mechanical polishing aqueous dispersion by mixing a liquid (I) and a liquid (II),
the liquid (I) being an aqueous dispersion including: the inorganic particles (A); at least one type of particles (B) selected from the group consisting of organic particles and organic-inorganic composite particles; and the water (F); and
the liquid (II) including: at least one compound (C) selected from the group consisting of quinolinecarboxylic acid, quinolinic acid, a divalent organic acid (excluding quinolinic acid), and a hydroxyl acid; and the water (F).

According to a fourth aspect of the invention, there is provided a kit for preparing the above-described chemical mechanical polishing aqueous dispersion by mixing a liquid (I), a liquid (II) and a liquid (III),
the liquid (I) being an aqueous dispersion including: the inorganic particles (A); at least one type of particles (B) selected from the group consisting of organic particles and organic-inorganic composite particles; and the water (F);
the liquid (II) including: at least one compound (C) selected from the group consisting of quinolinecarboxylic acid, quinolinic acid, a divalent organic acid (excluding quinolinic acid), and a hydroxyl acid; and the water (F); and
the liquid (III) including the oxidizing agent (E) and the water (F).

In this kit, the liquid (I) may further include at least one component selected from: at least one compound (C) selected from the group consisting of quinolinecarboxylic acid, quinolinic acid, a divalent organic acid (excluding quinolinic acid), and a hydroxyl acid; at least one compound (D) selected from the group consisting of benzotriazole and benzotriazole derivatives; and the oxidizing agent (E).

In this kit, the liquid (II) may further include at least one component selected from: the inorganic particles (A); at least one type of particles (B) selected from the group consisting of organic particles and organic-inorganic composite particles; at least one compound (D) selected from the group consisting of benzotriazole and benzotriazole derivatives; and the oxidizing agent (E).

According to a fifth aspect of the invention, there is provided a chemical mechanical polishing method, comprising:

chemically and mechanically polishing a polishing target by using a chemical mechanical polishing aqueous dispersion having, when chemically and mechanically polishing a copper film, a barrier metal film, and an insulating film under identical conditions, a ratio "$R_{Cu}/R_{BM}$" of a polishing rate $R_{Cu}$ of the copper film to a polishing rate $R_{BM}$ of the barrier metal film of 50 or more and a ratio "$R_{Cu}/R_{In}$" of the polishing rate $R_{Cu}$ of the copper film to a polishing rate $R_{In}$ of the insulating film of 50 or more; and then

chemically and mechanically polishing the polishing target by using the above-described chemical mechanical polishing aqueous dispersion.

According to the above chemical mechanical polishing aqueous dispersion, chemical mechanical polishing method using the chemical mechanical polishing aqueous dispersion, and kit for preparing the chemical mechanical polishing aqueous dispersion, various polishing targets can be can be efficiently polished and a sufficiently planarized and accurately finished surface can be produced. Moreover, occurrence of scratches or peeling on a semiconductor substrate (polishing target) can be prevented when chemically and mechanically polishing a semiconductor substrate having an insulating film formed of a low-dielectric-constant material exhibiting a low mechanical strength.

BRIEF DESCRIPTION OF THE SEVERAL VIEWS OF THE DRAWING

FIGS. 1A to 1C are schematic views showing an example of a polishing target surface of a chemical mechanical polishing method according to a second embodiment of the invention.
FIGS. 2A to 2C are schematic views showing an example of a polishing target surface of a chemical mechanical polishing method according to the second embodiment of the invention.

DETAILED DESCRIPTION OF THE EMBODIMENT

1. Chemical Mechanical Polishing Aqueous Dispersion

A chemical mechanical polishing aqueous dispersion according to a first embodiment of the invention includes (A) inorganic particles, (B) at least one type of particles selected from the group consisting of organic particles and organic-inorganic composite particles, (C) at least one compound selected from the group consisting of quinolinecarboxylic acid, quinolinic acid, a divalent organic acid (excluding quinolinic acid), and a hydroxyl acid, (D) at least one compound selected from the group consisting of benzotriazole and benzotriazole derivatives, (E) an oxidizing agent, and (F) water. The chemical mechanical polishing aqueous dispersion contains the component (A) in an amount of 0.05 to 2.0 wt% and the component (B) in an amount of 0.005 to 1.5 wt%, has a ratio ($W_A/W_B$) of the amount ($W_A$) of the component (A) to the amount ($W_B$) of the component (B) of 0.1 to 200 the component (E) in an amount 0.05 to 0.5 wt%, and has a pH of 1.0 to 5.0. The chemical mechanical polishing aqueous dispersion according to the first embodiment of the invention is produced by dissolving and/or dispersing the above components in an aqueous medium.
The components used in the chemical mechanical polishing aqueous dispersion according to the first embodiment of the invention arc described below in detail.

1.1. Component (A)

The component (A) (hereinafter also called "inorganic particles (A)") used in the chemical mechanical polishing aqueous dispersion according to the first embodiment of the invention is inorganic particles. As examples of the inorganic particles (A), silica, alumina, titania, zirconia, ceria, and the like can be given. As examples of the silica, fumed silica, silica synthesized by a sol-gel method, colloidal silica, and the like can be given. The fumed silica may be obtained by reacting silicon chloride or the like with oxygen and water in a gaseous phase. The silica synthesized by the sol-gel method may be obtained by hydrolysis and/or condensation of an alkoxysilicon compound as the raw material. The colloidal silica may be obtained by an inorganic colloid method using a raw material purified in advance, for example.
As the inorganic particles (A), the silica is preferably used.
It is preferable that the inorganic particles (A) have an impurity metal content of 10 ppm or less, more preferably 5 ppm or less, still more preferably 3 ppm or less, and particularly preferably 1 ppm or less. As examples of the impurity metal, iron, nickel, zinc, and the like can be given.
The average dispersed particle diameter of the inorganic particles (A) is preferably 5 to 1,000 nm, more preferably 7 to 700 nm, and still more preferably 10 to 500 nm. The balance between the polishing rate and the quality (e.g. smoothness) of the polished surface can be achieved by using the inorganic particles (abrasives) having an average dispersed particle diameter within this range.
The inorganic particles (A) are used in the chemical mechanical polishing aqueous dispersion according to the first embodiment in an amount of 0.05 to 2.0 wt%, preferably 0.1 to 2.0 wt%, and still more preferably 0.1 to 1.5 wt% of the total amount of the chemical mechanical polishing aqueous dispersion. If the amount of the inorganic particles (A) is 0.05 to 2.0 wt% of the total amount of the chemical mechanical polishing aqueous dispersion, a chemical mechanical polishing aqueous dispersion exhibiting a high polishing rate can be obtained while minimizing damage to a low-dielectric-constant insulating film.

1.2. Component (B)

The component (B) used in the chemical mechanical polishing aqueous dispersion according to the first embodiment is at least one type of particles selected from the group consisting of organic particles and organic-inorganic composite particles.

As examples of the organic particles which may be used as the component (B), polyvinyl chloride, styrene (co) polymer, polyacctal, polyester, polyamide, polycarbonate, olefin (co)polymer, phenoxy resin, acrylic (co)polymer, and the like can be given. As examples of the olefin (co)polymer, polyethylene, polypropylene, poly-1-butene, poly-4-methyl-1-pentene, and the like can be given. As examples of the acrylic (co)polymer, polymethyl methacrylate and the like can be given.

The type, configuration, and the like of the organic-inorganic composite particles which may be used as the component (B) are not particularly limited insofar as the above organic particles and inorganic particles are integrally formed to such an extent that the organic particles and the inorganic particles are not easily separated during chemical mechanical polishing. As examples of the inorganic particles which may used for the organic-inorganic composite particles, the inorganic particles given as examples of the inorganic particles (A) and the like can be given.

The organic-inorganic composite particles may have the following configuration, for example.

(i) Organic-inorganic composite particles obtained by polycondensation of an alkoxide compound of a metal or silicon in the presence of organic particles. As examples of the alkoxide compound of a metal or silicon, an alkoxysilane, aluminum alkoxide, titanium alkoxide, and the like can be given. The resulting polycondensate may be bonded to a functional group of the organic particle either directly or through an appropriate coupling agent (e.g. silane coupling agent).

(ii) Organic-inorganic composite particles in which organic particles and inorganic particles having zeta potentials of opposite polarities (positive or negative) are bonded by an electrostatic force. In this case, the composite particles may be formed by mixing the organic particles and the inorganic particles in a pH region in which the organic particles and the inorganic particles have zeta potentials of opposite polarities, or may be formed by mixing the organic particles and the inorganic particles in a pH region in which the organic particles and the inorganic particles have zeta potentials of an identical polarity, and changing the solution properties to a pH region in which the organic particles and the inorganic particles have zeta potentials of opposite polarities.

(iii) Organic-inorganic composite particles obtained by polycondensation of an alkoxide compound of a metal or silicon in the presence of the composite particles (ii). As the alkoxide compound of a metal or silicon, the alkoxide compound given for the organic-inorganic composite particles (i) may be used.

The average dispersed particle diameter of the particles used as the component (B) is preferably 20 to 5,000 nm, more preferably 30 to 2,000 nm, and still more preferably 50 to 1,000 nm. An excellent polished surface can be obtained at an appropriate polishing rate by adjusting the average dispersed particle diameter of the component (B) within this range.

The component (B) is used in an amount of 0.005 to 1.5 wt%, preferably 0.01 to 1.0 wt%, and still more preferably 0.05 to 0.5 wt% of the total amount of the chemical mechanical polishing aqueous dispersion according to the first embodiment. If the amount of the component (B) is 0.005 to 1.5 wt% of the total amount of the chemical mechanical polishing aqueous dispersion which minimizes dishing in an interconnect area and defects on a substrate can be obtained.

The ratio ($W_A/W_B$) of the amount ($W_A$) of the component (A) to the amount ($W_B$) of the component (B) is 0.1 to 200, preferably 0.5 to 150, and still more preferably 1 to 100. If the ratio ($W_A/W_B$) of the particles (A) and (B) is 0.1 to 200, a chemical mechanical polishing aqueous dispersion can be obtained which minimizes damage to an insulating film and dishing in an interconnect area when chemically and mechanically polishing a semiconductor device having an insulating film formed of a low-dielectric-constant material.

1.3. Component (C)

The component (C) used in the chemical mechanical polishing aqueous dispersion according to the first embodiment is at least one compound selected from the group consisting of quinolinecarboxylic acid, quinolinic acid, a divalent organic acid (excluding quinolinic acid), and a hydroxyl acid.

The component (C) is preferably a compound having four or more carbon atoms. As examples of the divalent carboxylic acid having four or more carbon atoms, maleic acid, succinic acid, fumaric acid, glutaric acid, adipic acid, and the like can be given. As examples of the hydroxyl acid having four or more carbon atoms, citric acid, malic acid, tartaric acid, and the like can be given.

The component (C) is preferably at least one compound selected from quinaldic acid (2-quinolinccarboxylic acid), quinolinic acid (2,3-pyridinedicarboxylic acid), maleic acid, citric acid, and malic acid.

The organic acid is used in an amount of preferably 0.005 to 3.0 wt%, and still more preferably 0.01 to 2.0 wt% of the total amount of the chemical mechanical polishing aqueous dispersion- If the amount of the component (C) is 0.005 to 3.0 wt%, the balance between the polishing rate and an excellent polished surface can be achieved.

### 1.4. Component (D)

The component (D) used in the chemical mechanical polishing aqueous dispersion according to the first embodiment is at least one compound selected from the group consisting of benzotriazole and benzotriazole derivatives. The term "benzotriazole derivative" used herein refers to a compound obtained by replacing at least one hydrogen atom of benzotriazole with a functional group such as a carboxyl group, methyl group, amino group, or hydroxyl group.

As the component (D), benzotriazole, methylbenzotriazole, 4-carboxybenzotriazole and its salt, 7-carboxybenzotriazole and its salt, benzotriazole butyl ester, 1-hydroxymethylbenzotriazole, 1-hydroxybenzotriazole, 1-(2,3-dihydroxypropyl)benzotriazole, 1-(2-hydroxyethyl)benzotriazole, 2-(benzotriazyl)ethanesulfonic acid and its salt, 1-(2-ethylhexylaminomethyl)benzotriazole, and the like are preferable. Of these, benzotriazole, methylbenzotriazole, 4-carboxybenzotriazole and its salt, 7-carboxybenzotriazole and its salt, benzotriazole butyl ester, 1-hydroxymcthylbenzotriazole, and 1-hydroxybenzotriazole are still more preferable, with benzotriazole being most preferable.

The component (D) is used in an amount of preferably 0.01 to 5.0 wt%, and still more preferably 0.05 to 2.0 wt% of the total amount of the chemical mechanical polishing aqueous dispersion. If the amount of the component (D) is 0.01 to 5.0 wt% of the total amount of the chemical mechanical polishing aqueous dispersion, the balance between the polishing rate and an excellent polished surface can be achieved.

### 1.5. Component (E)

The component (E) used in the chemical mechanical polishing aqueous dispersion according to the first embodiment is an oxidizing agent (hereinafter also called "oxidizing agent (E)"). As examples of the oxidizing agent (E), a persulfate, hydrogen peroxide, inorganic acid, organic peroxide, polyvalent metal salt, and the like can be given. As examples of the persulfate, ammonium persulfate, potassium persulfate, and the like can be given. As examples of the inorganic acid, nitric acid, sulfuric acid, and the like can be given. As examples of the organic peroxide, peracetic acid, perbenzoic acid, tert-butyl hydropcroxidc, and the like can be given. As examples of the polyvalent metal salt, a permanganic acid compound, dichromic acid compound, and the like can be given. As examples of the permanganic acid compound, potassium permanganate and the like can be given. As examples of the dichromic acid compound, potassium dichromate and the like can be given. As the oxidizing agent (E), hydrogen peroxide, persulfate, and inorganic acid are preferable, with hydrogen peroxide being particularly preferable.

The oxidizing agent (E) is used in an amount of 0.05 to 0.5 wt % of the total amount of the chemical mechanical polishing aqueous dispersion.

It should be noted that the chemical mechanical polishing aqueous dispersion may further include an appropriate polyvalent metal ion when using hydrogen peroxide as the oxidizing agent (E). The addition of the polyvalent metal ion to the chemical mechanical polishing aqueous dispersion containing hydrogen peroxide may promote the function of the hydrogen peroxide as the oxidizing agent and improve the polishing rate.

### 1.6. Component (F)

The component (F) used in the chemical mechanical polishing aqueous dispersion according to the first embodiment is water (hereinafter also called "water (F)"). The water (F) functions as an aqueous medium of the chemical mechanical polishing aqueous dispersion. As an example of the aqueous medium, a mixed medium of the water (F) and an organic solvent miscible with water (e.g. alcohol or alkylene glycol derivative) can be given. It is preferable that the component (F) be water, a mixed medium of water and a water-soluble alcohol, or the like. As examples of the water-soluble alcohol, methanol, ethanol, and the like can be given. It is still more preferable that the component (F) be a mixed medium of water and methanol.

### 1.7. Other components (G)

The chemical mechanical polishing aqueous dispersion according to the first embodiment may optionally include (G) components other than the above-described components. As examples of the components (G), a surfactant, pH adjusting agent, and the like may be given.

As examples of the surfactant, a cationic surfactant, anionic surfactant, ampholytic surfactant, nonionic surfactant, water-soluble polymer, and the like can be given. It is preferable to use the anionic surfactant, nonionic surfactant, or water-soluble polymer.

As examples of the anionic surfactant, a carboxylate, sulfonate, sulfate salt, phosphate salt, and the like can be given. As examples of the carboxylate, fatty acid soap, alkyl ether carboxylate, and the like can be given. As examples of the sulfonate, alkylbenzenesulfonate, alkylnaphthalenesulfonate, alpha-olefin sulfonate, and the like can be given. As examples of the sulfate salt, a higher alcohol sulfate salt, alkyl ether sulfate, polyoxyethylene alkyl phenyl ether sulfate, and the like can be given. As examples of the phosphate salt, an alkyl phosphate salt and the like can be given. It is preferable to use the sulfonate. It is still more preferable to use the alkylbenzenesulfonate, with potassium dodecylbenzenesulfonate being particularly preferable.

As examples of the nonionic surfactant, a polyethylene glycol type surfactant, acetylene glycol, ethylene oxide addition product of acetylene glycol, acetylene alcohol, and the like can be given.

As examples of the pH adjusting agent, an organic base, inorganic base, and inorganic acid can be given.

As examples of the organic base, tctramethylammonium hydroxide, triethylamine, and the like can be given.

As examples of the inorganic base, ammonia, potassium hydroxide, and the like can be given.

As examples of the inorganic acid, nitric acid, sulfuric acid, and the like can be given.

The pH of the chemical mechanical polishing aqueous dispersion according to the first embodiment is 1.0 to 5.0, preferably 1.5 to 4.5, and still more preferably 2.0 to 4.0. The balance between the polishing rate and an excellent polished surface can be achieved by adjusting the pH of the chemical mechanical polishing aqueous dispersion in the range from 1.0 to 5.0. It should be noted that the above pH value is measured at 25°C.

1.8. Kit for preparing chemical mechanical polishing aqueous dispersion

The chemical mechanical polishing aqueous dispersion according to the first embodiment of the invention may be supplied in a state in which the prepared chemical mechanical polishing aqueous dispersion can be directly used as a polishing composition. Or, a polishing composition containing each component of the chemical mechanical polishing aqueous dispersion at a high concentration (i.e. concentrated polishing composition) may be provided, and the concentrated polishing composition may be diluted before use to obtain a desired chemical mechanical polishing aqueous dispersion.

For example, the chemical mechanical polishing aqueous dispersion according to the first embodiment may be separately provided as two or more liquids (e.g. two or three liquids), and the liquids may be mixed before use. The chemical mechanical polishing aqueous dispersion according to the first embodiment may be prepared by mixing two or more liquids using first to third kits described below, for example.

1.8.1. First kit

The first kit is a kit for preparing the chemical mechanical polishing aqueous dispersion according to the first embodiment by mixing a liquid (I) and a liquid (II). In the first kit, the liquid (I) includes the inorganic particles (A), at least one type of particles (B) selected from the group consisting of organic particles and organic-inorganic composite particles, at least one compound (C) selected from the group consisting of quinolinecarboxylic acid, quinolinic acid, divalent organic acid (excluding quinolinic acid), and hydroxyl acid, at least one compound (D) selected from the group consisting of benzotriazole and benzotriazole derivatives, and the water (F), and the liquid (II) includes the oxidizing agent (E) and the water (F).

When preparing the liquid (I) and the liquid (II) of the first kit, it is necessary to determine the concentration of each component in the liquid (I) and the liquid (II) so that each component is included in the aqueous dispersion obtained by mixing the liquid (I) and the liquid (II) in the above-mentioned concentration range. Each of the liquid (I) and the liquid (II) may include each component at a high concentration (i.e. may be concentrated). In this case, the liquid (I) and the liquid (II) may be diluted before use. According to the first kit, the storage stability of the oxidizing agent (F) can be improved by separately providing the liquid (I) and the liquid (II).

When preparing the chemical mechanical polishing aqueous dispersion according to the first embodiment using the first kit, it suffices that the liquid (I) and the liquid (II) be separately provided (supplied) and integrally mixed at the time of polishing. The mixing method and the timing of mixing are not particularly limited.

For example, the liquid (I) and the liquid (II) may be separately supplied to a polishing system and mixed on a platen. Or, the liquid (I) and the liquid (II) may be mixed before being supplied to the polishing system, or may be mixed in the polishing system when supplied through a line, or may be mixed in a mixing tank additionally provided. A line mixer or the like may be used to obtain a more uniform aqueous dispersion.

1.8.2. Second kit

A second kit is a kit for preparing the chemical mechanical polishing aqueous dispersion according to the first embodiment by mixing a liquid (I) and a liquid (II). In the second kit, the liquid (I) is an aqueous dispersion including the inorganic particles (A), at least one type of particles (B) selected from the group consisting of organic particles and organic-inorganic composite particles, and the water (F), and the liquid (II) includes at least one compound (C) selected from the group consisting of quinolinecarboxylic acid, quinolinic acid, divalent organic acid (excluding quinolinic acid), and hydroxyl acid, and the water (F).

When preparing the liquid (I) and the liquid (II) of the second kit, it is necessary to determine the concentration of each component in the liquid (I) and the liquid (II) so that each component is included in the aqueous dispersion obtained by mixing the liquid (I) and the liquid (II) in the above-mentioned concentration range. Each of the liquid (I) and the liquid (II) may include each component at a high concentration (i.e. may be concentrated). In this case, the liquid (I) and the liquid (II) may be diluted before use. According to the second kit, the storage stability of the aqueous dispersion can be improved by separately providing the liquid (I) and the liquid (II).

When preparing the chemical mechanical polishing aqueous dispersion according to the first embodiment using the first kit, it suffices that the liquid (I) and the liquid (II) be separately provided (supplied) and integrally mixed at the time of polishing. The mixing method and the timing of mixing are not particularly limited.

For example, the liquid (I) and the liquid (II) may be separately supplied to a polishing system and mixed on a platen. Or, the liquid (I) and the liquid (II) may be mixed before being supplied to the polishing system, or may be mixed in the polishing system when supplied through a line, or may be mixed in a mixing tank additionally provided. A line mixer or the like may be used to obtain a more uniform aqueous dispersion.

1.8.3. Third kit

The third kit is a kit for preparing the chemical mechanical polishing aqueous dispersion according to the first embodiment by mixing a liquid (I), a liquid (II), and a liquid (III). In the third kit, the liquid (I) is an aqueous dispersion including the inorganic particles (A), at least one type of particles (B) selected from the group consisting of organic particles and organic-inorganic composite particles, and the water (F), the liquid (II) includes at least one compound (C) selected from the group consisting of quinolinecarboxylic acid, quinolinic acid, divalent organic acid (excluding quinolinic acid), and hydroxyl acid and the water (F), and the liquid (III) includes the oxidizing agent (E) and the water (F).

When preparing the liquid (I), the liquid (II), and the liquid (III) of the third kit, it is necessary to determine the concentration of each component in the liquid (I), the liquid (II), and the liquid (III) so that each component is included in the aqueous dispersion obtained by mixing the liquid (I), the liquid (II), and the liquid (III) in the above-mentioned concentration range. Each of the liquid (I), the liquid (II), and the liquid (III) may include each component at a high concentration (i.e. may be concentrated)- In this case, the liquid (I), the liquid (II), and the liquid (III) may be diluted before use. According to the third kit, the storage stability of the aqueous dispersion can be improved by separately providing the liquid (I), the liquid (II), and the liquid (III).

When preparing the chemical mechanical polishing aqueous dispersion according to the first embodiment using the third kit, it suffices that the liquid (I), the liquid (II), and the liquid (III) be separately provided (supplied) and integrally mixed at the time of polishing. The mixing method and the timing of mixing are not particularly limited.

For example, the liquid (I), the liquid (II), and the liquid (III) may be separately supplied to a polishing system and mixed on a platen. Or, the liquid (I), the liquid (II), and the liquid (III) may be mixed before being supplied to the polishing system, or may be mixed in the polishing system when supplied through a line, or may be mixed in a mixing tank additionally provided. A line mixer or the like may be used to obtain a more uniform aqueous dispersion.

In the second and third kits, the liquid (I) may further include at least one component selected from at least one compound (C) selected from the group consisting of quinolinecarboxylic acid, quinolinic acid, divalent organic acid (excluding quinolinic acid), and hydroxyl acid, at least one compound (D) selected from the group consisting of benzotriazole and benzotriazole derivatives, and the oxidizing agent (E), and the liquid (II) may further include at least one component selected from the inorganic particles (A), at least one type of particles (B) selected from the group consisting of organic particles and organic-inorganic composite particles, at least one compound (D) selected from the group consisting of benzotriazole and benzotriazole derivatives, and the oxidizing agent (E).

2. Chemical Mechanical Polishing Method

A chemical mechanical polishing method according to a second embodiment of the invention includes chemically and mechanically polishing a polishing target using the above-described chemical mechanical polishing aqueous dispersion. More specifically, the above-described chemical mechanical polishing aqueous dispersion may be suitably used in the chemical mechanical polishing method according to the second embodiment of the invention as a chemical mechanical polishing aqueous dispersion for a second polishing step of two-stage polishing for forming a copper damascene interconnect described later, for example. In particular, when using a first chemical mechanical polishing aqueous dispersion described later as a chemical mechanical polishing aqueous dispersion for the first polishing step, the above-described chemical mechanical polishing aqueous dispersion exhibits more excellent polishing properties by using the chemical mechanical polishing aqueous dispersion as the chemical mechanical polishing aqueous dispersion for the second polishing step. The polishing target to be chemically and mechanically polished includes at least a copper film, a barrier metal film, and an insulating film.

The chemical mechanical polishing method according to the second embodiment includes a first polishing step of chemically and mechanically polishing a polishing target surface using a chemical mechanical polishing aqueous dispersion (hereinafter may be called "first polishing aqueous dispersion") having, when chemically and mechanically polishing each of a copper film, and a barrier metal film under identical conditions, a ratio ($R_{Cu}/R_{BM}$) of a polishing rate ($R_{Cu}$) of the copper film to a polishing rate ($R_{BM}$) of the barrier metal film of 50 or more, and a second polishing step of chemically and mechanically polishing the polishing target surface which has been chemically and mechanically polished in the first polishing step using the above-described chemical mechanical polishing aqueous dispersion (hereinafter may be called "second polishing aqueous dispersion").

In the second embodiment, the first polishing step and the second polishing step may be continuously performed using an identical polishing system in a state in which the polishing target is installed in the polishing system by sequentially changing the polishing aqueous dispersion supplied. Or, the polishing target may be removed from a polishing system after the first polishing step and again installed in the polishing system after changing the polishing aqueous dispersion supplied, and the second polishing step may be then performed.

The first polishing step and the second polishing step may be performed using different polishing systems.

When using a polishing system provided with two or more polishing pads, the first polishing step and the second polishing step may be performed using different polishing pads, or a single polishing pad may be used in the first polishing step and the second polishing step.

The copper film (polishing target) is not limited to a film formed only of copper. For example, the copper film may be a film formed of a copper alloy containing 95 wt% or more of copper, such as a copper-silicon alloy or a copper-aluminum alloy.

The barrier metal film (polishing target) is formed of a metal having high hardness such as tantalum or titanium, or a nitride or an oxide of such a metal. The barrier metal film may be formed of an alloy such as a tantalum-niobium alloy instead of a single element. When the barrier metal film is formed of a nitride such as tantalum nitride or titanium nitride, the nitride may not be a pure product (i.e. may contain impurities). The material for the barrier metal film is particularly preferably tantalum and/or tantalum nitride.

The barrier metal film is generally formed of a single substance such as tantalum or titanium. Note that different materials (e.g. tantalum film and tantalum nitride film) may be formed on a single substrate as the barrier metal film.

As examples of the insulating film (polishing target), an $SiO_2$ film, a borophosphosilicate glass (BPSG) film formed by adding small amounts of boron and phosphorus to $SiO_2$, an insulating film called fluorine-doped silicate glass (FSG) prepared by doping $SiO_2$ with fluorine, a low-dielectric-constant silicon oxide-based insulating film, an organic insulating film, and the like can be given.

As examples of the $SiO_2$ film, a thermal oxide film, a plasma enhanced-TEOS (PETEOS) film, a high-density plasma enhanced-TEOS film (HDP film), a silicon oxide film produced by a thermal CVD method, and the like can be given.

The thermal oxide film may be formed by subjecting silicon heated at a high temperature to an oxidizing atmosphere to chemically react silicon with oxygen or water. The PETEOS film may be formed by chemical vapor deposition using tetraethylorthosilicate (TEOS) as the raw material while accelerating the reaction using plasma. The HDP film may be formed by chemical vapor deposition using tetraethylorthosilicate (TEOS) as the raw material while accelerating the reaction using high-density plasma.

The silicon oxide film may be formed by a thermal CVD method. As examples of the thermal CVD method, an atmospheric-pressure CVD (AP-CVD) method and a low-pressure CVD (LP-CVD) method can be given. The borophosphosilicate glass (BPSG) film may be produced by the AP-CVD method or the LP-CVD method. The FSG (fluorine-doped silicate glass) insulating film may be formed by chemical vapor deposition while accelerating the reaction using high-density plasma.

The low-dielectric-constant silicon oxide-based insulating film may be produced by applying the raw material to a substrate by spin coating or the like, and heating the applied raw material in an oxidizing atmosphere. As examples of such a low-dielectric-constant silicon oxide-based insulating film, a hydrogen silsesquioxane (HSQ) film using triethoxysilane as the raw material, a methyl silsesquioxane (MSQ) film using tetraethoxysilane and a small amount of methyl trimethoxysilane as the raw materials, and other low-dielectric-constant silicon oxide-based insulating films using a silane compound as the raw material can be given. The low-dielectric-constant silicon oxide-based insulating film may be provided with a lower dielectric constant by mixing appropriate organic polymer particles into the raw material to allow the polymer to be burnt during the heating step to form pores, for example.

As examples of the organic insulating film, a low-dielectric-constant organic insulating film using an organic polymer such as a polyarylene polymer, polyarylene ether polymer, polyimide polymer, or benzocyclobutene polymer, and the like can be given.

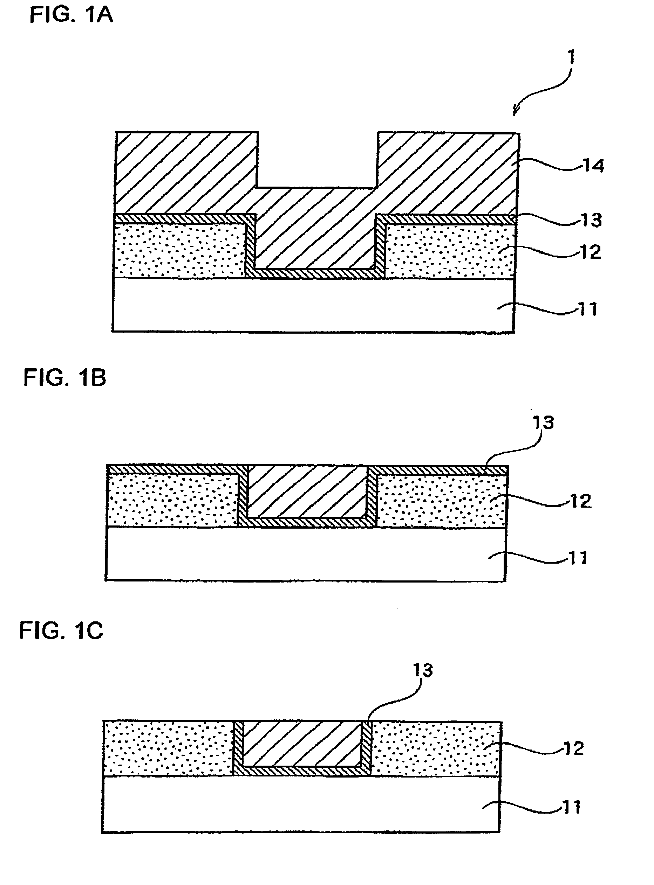

As an example of the polishing target of the chemical mechanical polishing method according to the second embodiment, a composite substrate material 1 having a structure as shown in FIG 1A can be given. The composite substrate material I includes a substrate 11 formed of silicon or the like, an insulating film 12 formed by a PETEOS film (film formed by a CVD method using tetraethoxysilane) or the like which is stacked on the surface of the substrate 11 and in which an interconnect recess portion such as a groove is formed, a barrier metal film 13 provided to cover the surface of the insulating film 12 and the bottom and the inner wall of the interconnect recess portion and formed of a high-melting-point metal such as tantalum or tantalum nitride, and a metal film 14 formed of an interconnect material provided in the interconnect recess portion and formed on the barrier metal film 13.

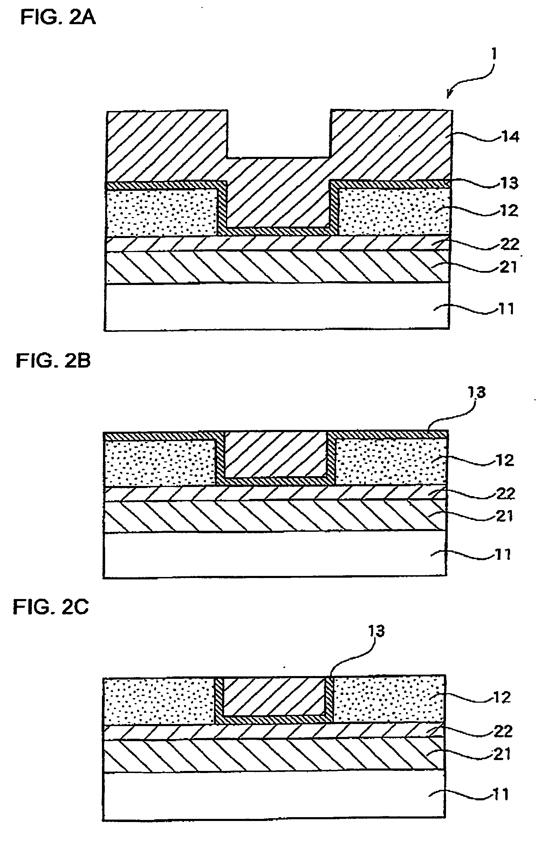

As shown in FIG 2A, the polishing target of the chemical mechanical polishing method according to the second embodiment may include an insulating film 21 provided between the substrate 11 and the insulating film 12 and formed of silicon oxide or the like, and an insulating film 22 formed of silicon nitride or the like on the insulating film 21.

In the chemical mechanical polishing method according to the second embodiment, the polishing target (composite substrate material 1) may be polished according to the following procedure, for example. In the first polishing step, the metal material of the metal film 14 is chemically and mechanically polished using the first polishing aqueous dispersion in an area other than the metal interconnect provided in the interconnect recess portion until the barrier metal film 13 is exposed, for example (see FIGS. 1B and 2B). In the second polishing step, the barrier metal film 13 is chemically and mechanically polished using the chemical mechanical polishing aqueous dispersion according to the first embodiment so that the barrier metal film formed in the area other than the bottom and the inner wall of the interconnect recess portion is completely removed. The surface of the insulating film 12 is also polished in the second polishing step, whereby a highly planarized damascene interconnect is obtained (see FIGS. 1C and 2C).

The first polishing aqueous dispersion has such polishing properties that the ratio ($R_{Cu}/R_{BM}$) of the polishing rate ($R_{Cu}$) of the copper film to the polishing rate ($R_{BM}$) of the barrier metal film is 50 or more and the ratio ($R_{Cu}//R_{In}$) of the polishing rate ($R_{Cu}$) of the copper film to the polishing rate ($R_{In}$) of the insulating film is 50 or more, as described above. The polishing rate ratio ($R_{Cu}/R_{BM}$) is preferably 60 or more, and still more preferably 70 or more. If the polishing rate ratio ($R_{Cu}/R_{BM}$) is less than 50, copper may remain to a large extent after the first polishing step in the area in which the copper film must be removed, whereby the second polishing step may require a longer polishing time. Moreover, a large amount of chemical mechanical polishing aqueous dispersion may be necessary.

The composition of the first polishing aqueous dispersion is not particularly limited insofar as the polishing rate ratio ($R_{Cu}/R_{BM}$) is in the above-mentioned range. It is preferable that the first polishing aqueous dispersion include abrasives, an organic acid, and an oxidizing agent in an aqueous medium, for example. It is still more preferable that the first polishing aqueous dispersion include ammonia or an ammonium ion in addition to these components.

As the aqueous medium used for the first polishing aqueous dispersion, the aqueous media given as examples for the chemical mechanical polishing aqueous dispersion according to the first embodiment can be given. It is preferable to use only water.

As the abrasives used for the first polishing aqueous dispersion, at least one type of abrasives selected from the particles given as examples the component (A) and (B) for the chemical mechanical polishing aqueous dispersion according to the first embodiment may be used. Of these, silicon dioxide, organic particles, or organic-inorganic composite particles are preferably used.

As the organic acid used for the first polishing aqueous dispersion, at least one compound selected from amino acids and the compounds given as examples of the component (C) for the chemical mechanical polishing aqueous dispersion according to the first embodiment may be used. Of these, glycine, alanine, citric acid, malic acid, 2-quinolinecarboxylic acid, or 2,3-pyridinedicarboxylic acid is preferably used, since a higher polishing rate ratio ($R_{Cu}/R_{BM}$) can be obtained.

As the oxidizing agent used for the first polishing aqueous dispersion, at least one compound selected from the oxidizing agent given as examples of the component (E) for the chemical mechanical polishing aqueous dispersion according to the first embodiment may be used. Of these, hydrogen peroxide or persulfate is preferable, with ammonium persulfate being particularly preferable.

The first polishing aqueous dispersion may further include ammonia or an ammonium ion. When the first polishing aqueous dispersion includes an ammonium ion, the ammonium ion may be produced from an ammonium salt of the above-mentioned organic acid or an ammonium salt of the above-mentioned inorganic acid as the oxidizing agent. Or, the ammonium ion may be added as the counter cation of the anionic surfactant which may be arbitrarily added.

The abrasives are used in an amount of preferably 0.001 to 3 wt%, more preferably 0.01 to 3 wt%, still more preferably 0.01 to 2.5 wt%, and particularly preferably 0.01 to 2 wt% of the total amount of the first polishing aqueous dispersion.

The organic acid is used in an amount of preferably 0.01 to 10 wt%, and still more preferably 0.1 to 5.0 wt% of the total amount of the first polishing aqueous dispersion.

The oxidizing agent is used in an amount of preferably 0.01 to 10 wt%, and still more preferably 0.02 to 5.0 wt% of the total amount of the first polishing aqueous dispersion.

When the first polishing aqueous dispersion includes ammonia or an ammonium ion, the amount of ammonia or ammonium ion used in the first polishing aqueous dispersion is preferably 5.0 mol/l or less, more preferably 0.01 to 5 mol/l, still more preferably 0.01 to 1.0 mol/l, and particularly preferably 0.03 to 0.5 mol/l.

The first polishing aqueous dispersion may arbitrarily include a surfactant, benzotriazole or a benzotriazole derivative, an anti-foaming agent, and the like.

As examples of the surfactant, a cationic surfactant, anionic surfactant, ampholytic surfactant, nonionic surfactant, water-soluble polymer, and the like can be given.

As the benzotriazole or benzotriazole derivative, the compounds given as examples of the benzotriazole or benzotriazole derivative (D) for the chemical mechanical polishing aqueous dispersion according to the first embodiment can be given. The benzotriazole or benzotriazole derivative is used in an amount of preferably 5.0 wt% or less, more preferably 0.001 to 5.0 wt%, still more preferably 0.005 to 1.0 wt%, and particularly preferably 0.01 to 0.5 wt% of the total amount of the first polishing aqueous dispersion.

The pH of the first polishing aqueous dispersion may be set in the acidic region, the neutral region, or the alkaline region. When setting the pH of the first polishing aqueous dispersion in the acidic region, the pH of the first polishing aqueous dispersion is preferably 2.0 to 4.0. When setting the pH of the first polishing aqueous dispersion in the neutral region or the alkaline region, the pH of the first polishing aqueous dispersion is preferably 6.0 to 12.0. The pH of the first polishing aqueous dispersion is preferably 6.0 to 12.0.

Chemical mechanical polishing using the chemical mechanical polishing method according to the second embodiment may be performed under known polishing conditions using a commercially available chemical mechanical polishing system (e.g. "LGP510" or "LGP552" manufactured by Lapmaster SFT Corporation, "EPO-112" or "EPO-222" manufactured by Ebara Corporation, "Mirra" manufactured by Applied Materials, Inc., or "AVANTI-472" manufactured by IPEC).

Preferable polishing conditions are appropriately set depending on the chemical mechanical polishing system used. For example, when using "EPO-112" as the chemical mechanical polishing system, the first polishing step and the second polishing step may be carried out under the following conditions.

Platen rotational speed:

preferably 30 to 120 rpm, and still more preferably 40 to 100 rpm

Head rotational speed:

preferably 30 to 120 rpm, and still more preferably 40 to 100 rpm

Ratio of platen rotational speed/head rotational speed:

preferably 0.5 to 2, and still more preferably 0.7 to 1.5

Polishing pressure:

preferably 100 to 500 g/cm$^2$, and still more preferably 200 to 350 g/cm$^2$

Supply rate of chemical mechanical polishing aqueous dispersion:

preferably 50 to 300 ml/min, and still more preferably 100 to 200 ml/min

3. Examples

The invention is described below by way of examples. Note that the invention is not limited to the following examples.

3.1. Preparation of aqueous dispersion containing inorganic particles

3.1.1. Preparation of aqueous dispersion containing fumed silica particles

2 kg of fumed silica particles ("Aerosil #90" manufactured by Nippon Aerosil Co., Ltd., average primary particle diameter: 20 nm) were dispersed in 6.7 kg of ion-exchanged water using an ultrasonic mixer. The mixture was filtered through a filter having a pore diameter of 5 micrometers to obtain an aqueous dispersion containing 23 wt% of fumed silica particles. The average secondary particle diameter of the fumed silica contained in the aqueous dispersion was 220 nm.

3.1.2. Preparation of aqueous dispersion containing colloidal silica particles

3.1.2-1. Preparation of aqueous dispersion containing colloidal silica particles C1

A flask was charged with 75 parts by weight of 25 wt% aqueous ammonia, 40 parts by weight of ion-exchanged water, 165 parts by weight of ethanol, and 15 parts by weight of tetraethoxysilane. The mixture was heated to 60°C with stirring at a rotational speed of 180 rpm. After stirring the mixture at 60°C for two hours, the mixture was cooled to room temperature. An alcohol dispersion of colloidal silica particles was thus obtained.

An operation of removing the alcohol from the resulting dispersion at 80°C using a rotary evaporator while adding ion-exchanged water was performed several times. An aqueous dispersion containing 20 wt% of colloidal silica particles C1 was prepared in this manner.

The average primary particle diameter, the average secondary particle diameter, and the average degree of association of the colloidal silica particles C1 contained in the aqueous dispersion were respectively 15 nm, 40 nm, and 2.7.

3.1.2-2. Preparation of aqueous dispersions respectively containing colloidal silica particles C2 to C4

Aqueous dispersions respectively containing colloidal silica particles C2 to C4 were prepared in the same manner as in "3.1.2-1. Preparation of aqueous dispersion containing colloidal silica particles CI" except for changing the amounts of the 25 wt% aqueous ammonia, ethanol, and tetraethoxysilane as shown in Table 1.

TABLE 1

| Colloidal silica | Amount of raw meterial ammonia | | | Colloidal silica content of aqueous dispersion (wt%) | Average primary particle diameter (nm) | Average secondary particle diameter (nm) | Degree of association |
|---|---|---|---|---|---|---|---|
| | Aqueous (concentration: 25 wt%) (part by weight) | Ethanol (part by weight) | Tetraethoxysilane (part by weight) | | | | |
| C1 | 75 | 165 | 15 | 15.0 | 15 | 40 | 2.7 |
| C2 | 70 | 170 | 20 | 20.0 | 25 | 40 | 1.6 |
| C3 | 70 | 175 | 20 | 20.0 | 25 | 50 | 2.0 |
| C4 | 65 | 175 | 25 | 20.0 | 35 | 70 | 2.0 |

3.1.3. Preparation of aqueous dispersion containing organic-inorganic composite particles

3.1.3-1. Preparation of aqueous dispersion containing surface-treated organic particles

A flask was charged with 90 parts by weight of methyl methacrylate, 5 parts by weight of mcthoxy polyethylene glycol methacrylate ("NK Ester M-90G #400" manufactured by Shin-Nakamura Chemical Co., Ltd.), 5 parts by weight of 4-vinylpyridine, 2 parts by weight of an azo initiator ("V50" manufactured by Wako Pure Chemical Industries, Ltd.), and 400 parts by weight of ion-cxchangcd water. The mixture was heated to 70°C with stirring in a nitrogen gas atmosphere. The mixture was stirred at 70°C for six hours. The reaction mixture was diluted with ion-exchanged water to obtain an aqueous dispersion containing 10 wt% of polymethyl methacrylate particles having a functional group containing a cation of an amino group and a polyethylene glycol chain and having an average particle diameter of 150 nm. The polymerization yield was 95%.

A flask was charged with 100 parts by weight of the resulting aqueous dispersion. After the addition of 1 part by weight of mcthyltrimethoxysilane, the mixture was stirred at 40°C for two hours. The pH of the mixture was adjusted to 2.0 by adding a 1N nitric acid aqueous solution to obtain an aqueous dispersion containing surface-treated organic particles. The zeta potential of the surface-treated organic particles contained in the aqueous dispersion was +17 mV

3.1.3-2. Preparation of aqueous dispersion containing inorganic particles (colloidal silica particles)

Colloidal silica particles ("Snowtex O" manufactured by Nissan Chemical Industries, Ltd., average primary particle diameter: 12 nm) were dispersed in water. The pH of the mixture was adjusted using a 1N potassium hydroxide aqueous solution to obtain an aqueous dispersion containing 10 wt% of colloidal silica particles and having a pH of 8.0.

The zeta potential of the colloidal silica particles contained in the aqueous dispersion was -40 mV.

3.1.3-3. Preparation of aqueous dispersion containing organic-inorganic composite particles

50 parts by weight of the aqueous dispersion prepared in "3.1.3-2. Preparation of aqueous dispersion containing inorganic particles (colloidal silica particles)" was slowly added to 100 parts by weight of the aqueous dispersion prepared in "3.1.3-1. Preparation of aqueous dispersion containing surface-treated organic particles" in two hours with stirring. The mixture was then stirred for two hours to obtain an aqueous dispersion containing particles in which the silica particles adhered to the polymethyl methacrylate particles.

After the addition of 2 parts by weight of vinyltriethoxysilane to the resulting aqueous dispersion, the mixture was stirred for one hour. Then, 1 part by weight of tetraethoxysilane was added to the mixture. After stirring the mixture at 60°C for three hours, the mixture was cooled to room temperature to prepare an aqueous dispersion containing 10 wt% of organic-inorganic composite particles having an average particle diameter of 180 nm.

The organic-inorganic composite particles contained in the aqueous dispersion were observed using a scanning electron microscope. As a result, it was found that the silica particles adhered to 80% of the surface of each polymethyl methacrylate particle.

3.1.4. Preparation of aqueous dispersion containing organic particles

A flask was charged with 90 parts by weight of methyl methacrylate, 10 parts by weight of styrene, 5 parts by weight of acrylic acid, 2 parts by weight of ammonium persulfate, 0.1 parts by weight of a surfactant, and 400 parts by weight of ion-exchanged water. The mixture was heated to 70°C with stirring in a nitrogen gas atmosphere and polymerized for eight hours until the polymerization conversion rate reached approximately 100%. An aqueous dispersion containing organic particles formed of a polymethacrylate-styrene polymer having a carboxyl group and having an average particle diameter of 150 nm was thus obtained. The aqueous dispersion was then diluted with water to obtain an aqueous dispersion in which the amount of the organic particles was adjusted to 10 wt%.

3.1.5. Production of low-dielectric-constant insulating film

3.1.5-1. Preparation of polysiloxane sol

A mixed solution of 101.5 g of methyltrimethoxysilane, 276.8 g of methyl methoxypropionate, and 9.7 g of a tetraisopropoxytitanium/ethyl acetoacetate complex was heated to 60°C. A mixture of 92.2 g of gamma-butyrolactone and 20.1 g of water was added dropwise to the mixed solution in one hour. After the addition, the mixture was reacted at 60°C for one hour to obtain a polysiloxane sol.

3.1.5-2. Production of polystyrene particles

A flask was charged with 100 parts of styrene, 2 parts of an azo initiator ("V60" manufactured by Wako Pure Chemical Industries, Ltd.), 0.5 parts of potassium dodecylbenzenesulfonate, and 400 parts of ion-exchanged water. The mixture was heated to 70°C with stirring in a nitrogen gas atmosphere, and polymerized for six hours. Polystyrene particles having an average particle diameter of 150 nm were thus obtained. 3.15-3. Production of low-dielectric-constant insulating film

15 g of the polysiloxane sol obtained in "3.1.5-1. Preparation of polysiloxane sol" and 1 g of the polystyrene particles obtained in "3.1.5-2. Production of polystyrene particles" were mixed. The resulting mixture was applied to a 8-inch silicon substrate with a thermal oxide film by spin coating to form a coating. The coating was heated in an oven at 80°C for five minutes and at 200°C for five minutes. The coating was then heated under vacuum at 340°C for 30 minutes, at 360°C for 30 minutes, at 380°C for 30 minutes, and at 450°C for one hour to form a colorless transparent film with a thickness of 2000 angstroms.

The cross section of the film was observed using a scanning electron microscope. As a result, it was confirmed that a number of minute pores were formed. The film had a relative dielectric constant of 1.98, a modulus of elasticity of 3 GPa, and a porosity of 15%.

3.1.6. Preparation of first polishing aqueous dispersion and evaluation of polishing performance

3.1.6-1. Preparation of first polishing aqueous dispersion

2 kg of fumed silica particles ("Aerosil #90" manufactured by Nippon Aerosil Co, Ltd., primary particle diameter: 20 nm, secondary particle diameter: 220 nm) were dispersed in 6.7 kg of ion-exchanged water using an ultrasonic mixer. The mixture was filtered through a filter having a pore diameter of 5 micrometers to obtain an aqueous dispersion containing 23.0 wt% of fumed silica particles.

A polyethylene container was then charged with the resulting aqueous dispersion in such an amount that the weight of silica was 1.2 wt%. After the addition of 0.5 wt% of quinaldic acid, 0.05 wt% of "Surfynol 465" (manufactured by Air Products Japan, Inc., nonionic surfactant having a triple bond), and 1.0 wt% of ammonium persulfate, the mixture was diluted with ion-exchanged water. The mixture was then sufficiently stirred. After adjusting the pH of the mixture to 9.5 using a 1N potassium hydroxide aqueous solution, the mixture was filtered through a filter having a pore diameter of 5 micrometers to obtain a first polishing aqueous dispersion.

3.1.6-2. Evaluation of polishing performance of first polishing aqueous dispersion

3.1.6-2A. Chemical mechanical polishing experiment of unpatterned wafer

A polishing pad made of porous polyurethane ("IC1000" manufactured by Nitta Haas Inc.) was installed in a chemical mechanical polishing system ("EPO-112" manufactured by Ebara Corporation). Polishing rate measurement substrates given below were chemically and mechanically polished for one minute under the following polishing conditions while supplying the first polishing aqueous dispersion. The polishing rate was calculated by the following method.

(i) Polishing rate measurement substrate

- A substrate in which a copper film with a thickness of 15,000 angstroms was provided on an 8-inch silicon substrate with a thermal oxide film.
- A substrate in which a tantalum film with a thickness of 2,000 angstroms was provided on an 8-inch silicon substrate with a thermal oxide film.
- A substrate in which a tantalum nitride film with a thickness of 2,000 angstroms was provided on an 8-inch silicon substrate with a thermal oxide film.
- A substrate in which a PETEOS film with a thickness of 10,000 angstroms was provided on an 8-inch silicon substrate.

(ii) Polishing conditions

- Head rotational speed: 70 rpm

- Head load: 250 g/cm$^2$
- Platen rotational speed: 70 rpm
- Supply rate of first polishing aqueous dispersion: 200 ml/min

(iii) Calculation of polishing rate

The thicknesses of the copper film, the tantalum film, and the tantalum nitride film were measured after polishing using a resistivity mapping system ("OmniMap RS75" manufactured by KLA-Tencor Corporation), and the polishing rate was calculated from the thickness reduced by chemical mechanical polishing and the polishing time.
The thickness of the PETEOS film was measured after polishing using an optical interference type thickness measurement device ("FPT500" manufactured by SENTEC), and the polishing rate was calculated from the thickness reduced by chemical mechanical polishing and the polishing time.

(iv) Polishing rate

- Polishing rate of copper film ($R_{Cu}$): 5200 angstroms/min
- Polishing rate of tantalum film ($R_{BM}$ (Ta)): 30 angstroms/min
- Polishing rate of tantalum nitride film ($R_{BM}$ (TaN)): 40 angstroms/min
- Polishing rate of PETEOS film ($R_{In}$): 20 angstroms/min
- Polishing rate of copper film/polishing rate of tantalum film ($R_{Cu}/R_{BM}$): 173
- Polishing rate of copper film/polishing rate of tantalum nitride film ($R_{Cu}/R_{BM}$): 130
- Polishing rate of copper film/polishing rate of PETEOS film ($R_{Cu}/R_{In}$): 260

3.1.6-2B. Chemical mechanical polishing experiment of patterned substrate

A polishing pad made of porous polyurethane ("IC1000" manufactured by Nitta Haas Inc.) was installed in a chemical mechanical polishing system ("EPO-112" manufactured by Ebara Corporation). Two patterned substrates given below were chemically and mechanically polished under the following polishing conditions while supplying the first polishing aqueous dispersion.

(i) Patterned substrate

- "854 CMP 100" manufactured by SEMATECH; substrate obtained by forming recess portions of various patterns in a silicon substrate and stacking a tantalum film (thickness: 250 angstroms), a copper seed film (thickness: 1,000 angstroms), and a copper plating film (thickness: 10,000 angstroms) over the recess portions in that order.
- "854 CMP 101" manufactured by SEMATECH; substrate obtained by recess portions of various patterns in a silicon substrate and stacking a tantalum nitride film (thickness: 250 angstroms), a copper seed film (thickness: 1,000 angstroms), and a copper plating film (thickness: 10,000 angstroms) over the recess portions in that order.

(ii) Polishing conditions

- Head rotational speed: 70 rpm
- Head load: 250 g/cm$^2$
- Platen rotational speed: 70 rpm
- Supply rate of first polishing aqueous dispersion: 200 ml/min
- Polishing time: 2.75 min

It is estimated that, after the first polishing step, the entire copper film positioned above the barrier metal film is removed so that the upper surface of the barrier metal film is exposed.
After the first polishing step, the depth of dishing occurring in the copper interconnect area of the polishing target surface having a width of 100 micrometers was measured using a surface roughness meter ("P-10" manufactured by KLA-Tencor Corporation). As a result, the depth of dishing was 500 angstroms.

The term "dishing" used herein refers to the difference in height of the polished surface between the upper surface of the barrier metal film on each side of the copper interconnect at the measurement position and the lowest portion of the copper interconnect at the measurement position.

The copper interconnect area was observed for 200 unit areas (120x 120 micrometers) at random by darkfield illumination using an optical microscope to measure the number of unit areas in which scratches had occurred (number of scratches). As a result, the number of scratches was found to be zero.

3.2. Example 1

3.2.1. Preparation of second polishing aqueous dispersion (chemical mechanical polishing aqueous dispersion according to the first aspect of the invention)

A polyethylene bottle was charged with the aqueous dispersion containing the colloidal silica particles C1 prepared in "3.1.2-1. Preparation of aqueous dispersion containing colloidal silica particles C1" in such an amount that the amount of silica was 1 wt% and the aqueous dispersion containing organic-inorganic composite particles prepared in "3.1.3. Preparation of aqueous dispersion containing organic-inorganic composite particles" in such an amount that the amount of organic-inorganic composite particles was 0.1 wt%. After the addition of 0.2 wt% of benzotriazole, 0.1 wt% of maleic acid, and a 35 wt% hydrogen peroxide aqueous solution in such an amount that the amount of hydrogen peroxide was 0.3 wt%, the mixture was stirred for 15 minutes. After the addition of ion-exchanged water so that the total amount of the components was 100 wt%, the mixture was filtered through a filter having a pore diameter of 5 micrometers to obtain a second polishing aqueous dispersion S1 having a pH of 2.3.

3.2.2. Evaluation of polishing performance of second polishing aqueous dispersion

3.2.2-1. Polishing test of unpatterned substrate

A polishing pad made of porous polyurethane ("IC1000" manufactured by Nitta Haas Inc.) was installed in a chemical mechanical polishing system ("EPO-112" manufactured by Ebara Corporation). Polishing rate measurement substrates given below were chemically and mechanically polished for one minute under the following polishing conditions while supplying the second polishing aqueous dispersion. The polishing rate was calculated by the following method.

(i) Polishing rate measurement substrate

- A substrate in which a copper film with a thickness of 15,000 angstroms was provided on an 8-inch silicon substrate with a thermal oxide film.
- A substrate in which a tantalum film with a thickness of 2,000 angstroms was provided on an 8-inch silicon substrate with a thermal oxide film.
- A substrate in which a tantalum nitride film with a thickness of 2,000 angstroms was provided on an 8-inch silicon substrate with a thermal oxide film.
- A substrate in which a PETEOS film with a thickness of 10,000 angstroms was provided on an 8-inch silicon substrate.
- A substrate in which a low-dielectric-constant insulating film with a thickness of 2,000 angstroms produced in the "3.1.5. Production of low-dielectric-constant insulating film" was provided on an 8-inch silicon substrate with a thermal oxide film.

(ii) Polishing conditions

- Head rotational speed: 70 rpm
- Head load: 250 g/cm$^2$
- Platen rotational speed: 70 rpm
- Supply rate of second polishing aqueous dispersion: 200 ml/min

(iii) Calculation of polishing rate

The thicknesses of the copper film, the tantalum film, and the tantalum nitride film were measured after polishing using a resistivity mapping system ("OmniMap RS75" manufactured by KLA-Tencor Corporation), and the polishing rate was calculated from the thickness reduced by chemical mechanical polishing and the polishing time.

The thicknesses of the PETEOS film and the low-dielectric-constant insulating film were measured after polishing using an optical interference type thickness measurement device ("FPT500" manufactured by SENTEC), and the polishing rate was calculated from the thickness reduced by chemical mechanical polishing and the polishing time.

(iv) Polishing rate

- Polishing rate of copper film ($R_{Cu}$): 70 angstroms/min
- Polishing rate of tantalum film ($R_{BM}$ (Ta)): 550 angstroms/min
- Polishing rate of tantalum nitride film ($R_{BM}$ (TaN)): 620 angstroms/min
- Polishing rate of PETEOS film ($R_{In}$): 40 angstroms/min
- Polishing rate of low-dielectric-constant insulating film ($R_{In}$): 15 augsftoms/min
- Polishing rate of tantalum film/polishing rate of copper film ($R_{BM}$ (Ta)/$R_{Cu}$): 7.86
- Polishing rate of tantalum nitride film/polishing rate of copper film ($R_{BM}$ (TaN)/$R_{Cu}$): 8.86
- Polishing rate of tantalum film/polishing rate of PETEOS film ($R_{BM}$ (Ta)/$R_{In}$ (TEOS film)): 13.75
- Polishing rate of tantalum nitride film/polishing rate of PETEOS film ($R_{BM}$ (TaN)/$R_{In}$ (TEOS film)): 15.50
- Polishing rate of tantalum film/polishing rate of low-dielectric-constant insulating film ($R_{BM}$ (Ta)/$R_{In}$ (low-dielectric-constant insulating film)): 36.67
- Polishing rate of tantalum nitride film/polishing rate of low-dielectric-constant insulating film ($R_{BM}$ (TaN)/$R_{In}$ (low-dielectric-constant insulating film)): 41.33

(v) Evaluation of low-dielectric-constant insulating film after polishing

The presence or absence of peeling in the outer circumferential portion was observed by checking with eyes and using an optical microscope, respectively.

The number of scratches was evaluated by observing the entire polished surface by means of checking with eyes and using an optical microscope respectively and an unpatterned wafer surface inspection system ("Surfscan SP1" manufactured by KLA-Tencor Corporation).

3.2.2-2. Polishing test of patterned substrate

A polishing pad made of porous polyurethane ("IC 1000" manufactured by Nitta Haas Inc.) was installed in a chemical mechanical polishing system ("EPO-112" manufactured by Ebara Corporation). Two patterned substrates given below were chemically and mechanically polished in two stages under the following polishing conditions.

(i) Patterned substrate

- "854 CMP 100" manufactured by SEMATECH; substrate obtained by forming recess portions of various patterns in a silicon substrate and stacking a tantalum film (thickness: 250 angstroms), a copper seed film (thickness: 1,000 angstroms), and a copper plating film (thickness: 10,000 angstroms) over the recess portions in that order.
- "854 CMP 101" manufactured by SEMATECH; substrate obtained by recess portions of various patterns in a silicon substrate and stacking a tantalum nitride film (thickness: 250 angstroms), a copper seed film (thickness: 1,000 angstroms), and a copper plating film (thickness: 10,000 angstroms) over the recess portions in that order.

(ii) Polishing conditions for first polishing step

- Chemical mechanical polishing aqueous dispersion: first polishing aqueous dispersion prepared in "3.1.6-1. Preparation of first polishing aqueous dispersion"
- Supply rate of first polishing aqueous dispersion: 200 ml/min
- Head rotational speed: 70 rpm
- Head load: 250 g/cm$^2$

- Platen rotational speed: 70 rpm
- Polishing time: 2.75 min

(iii) Polishing conditions for second polishing step

- Chemical mechanical polishing aqueous dispersion: second polishing aqueous dispersion prepared in "3.2.1. Preparation of second polishing aqueous dispersion (chemical mechanical polishing aqueous dispersion according to the first aspect of the invention)"
- Supply rate of second polishing aqueous dispersion: 200 ml/min
- Head rotational speed: 70 rpm
- Head load: 250 g/cm$^2$
- Platen rotational speed: 70 rpm
- Polishing time: 0.68 min for "854 CMP 100" and 0.60 min for "854 CMP 101"

The polishing time was calculated by the following equation.

**Polishing time (min) = {thickness of barrier metal layer (angstrom) / polishing rate (angstrom/min) of barrier metal film (tantalum or tantalum nitride) calculated in "3.2.2-1. Polishing test of unpatterned substrate"} × 1.5 (min)**

It is estimated that, after the second polishing step, the entire barrier metal film positioned above the uppermost surface of the PETEOS film is removed so that the upper surface of the PETEOS film is exposed.

After the second polishing step, the depth of dishing occurring in the copper interconnect area of the polished surface having a width of 100 micrometers was measured using a surface roughness meter ("P-10" manufactured by KLA-Tencor Corporation). As a result, the depth of dishing was 330 angstroms for "854 CMP 100" and 320 angstroms for "854 CMP 101".

The term "dishing" used herein refers to the difference in height of the polished surface between the upper surface of the PETEOS film on each side of the copper interconnect at the measurement position and the lowest portion of the copper interconnect at the measurement position.

The amount of polishing of the insulating film in the unpatterned field area (field area greater than 120×120 micrometers) was calculated as the thickness reduced from initial thickness (5000 angstroms) by measuring the thickness after polishing using an optical interference type thickness measurement device ("FPT500" manufactured by SENTEC). As a result, the amount of polishing was 20 angstroms or less for "854 CMP 100" and "854 CMP 101".

The copper interconnect area was observed for 200 unit areas (120×120 micrometers) at random by darkfield illumination using an optical microscope to measure the number of unit areas in which scratches had occurred (number of scratches). As a result, the number of scratches was found to be zero for "854 CMP 100" and "854 CMP 101".

3.3. Examples 2 to 5 and Comparative Examples 1 and 2

Second polishing aqueous dispersions S2 to S5 and R1 and R2 were prepared in the same manner as in Example 1 except for changing the type and the amount of each component of the second polishing aqueous dispersion and the pH of the aqueous dispersion as shown in Table 2. In Table 2, the symbol "-" indicates that the corresponding component was not added. In Example 4, two types of particles were used as the component (B). In Example 5, two types of particles were used as the component (A).

The polishing performance was evaluated in the same manner as in Example I except for using each prepared aqueous dispersion as the second polishing aqueous dispersion instead of the chemical mechanical polishing aqueous dispersion S1. The results are shown in Table 3.

TABLE 2

| | Aqueous dispersion | Inorganic particle (A) | | Particle (B) | | $W_A/W_B$ | Organic acid (C) | | Component (D) | | Oxidizing agent (E) | | pH |
|---|---|---|---|---|---|---|---|---|---|---|---|---|---|
| | | Type | Amount $(W_A)$ (wt%) | Type | Amount $(W_a)$ (wt%) | | Type | Amount (wt%) | Type | Amount (wt%) | Type | Amount (wt%) | |
| Example 1 | S1 | C1 | 1.0 | Composite | 0.1 | 10 | Maleic acid | 0.1 | Benzotriazolec | 0.2 | Hydrogen peroxide | 0.3 | 2.3 |
| Example 2 | S2 | C2 | 1.3 | Composite | 1.0 | 1.3 | Quinaldic acid | 0.4 | Methylbenzotriazole | 0.05 | Hydrogen peroxide | 0.1 | 4.0 |
| Example 3 | S3 | C3 | 0.5 | Organic | 0.01 | 50 | Citric acid | 0.5 | Carboxybenrotriazole | 0.01 | Hydrogen peroxide | 0.1 | 2.7 |
| Example 4 | S4 | Furned silica | 0.2 | Composite Organic | 0.2 0.2 | 0.5 | Malic acid | 0.5 | Benzotriazole | 0.1 | Hydrogen peroxide | 0.05 | 2.7 |
| Example 5 | S5 | C1 C4 | 0.8 0.8 | Composite | 0.01 | 160 | Quinolinic acid | 0.2 | Benzotriazole | 0.4 | Hydrogen peroxide | 0.5 | 2.6 |
| Comparative Example 1 | R1 | Furned silica | 4.0 | None | - | - | Malic acid | 0.6 | Benzotriazole | 0.1 | Hydrogen peroxide | 0.1 | 3.0 |
| Comparative Example 2 | R2 | C4 | 0.2 | Composite | 7.5 | 0.03 | Malic acid | 0.6 | None | - | Hydrogen peroxide | 0.5 | 4.0 |

## TABLE 3

| | Example 1 | Example 2 | Example 3 | Example 4 | Example 5 | Comparative Example 1 | Comparative Example 2 |
|---|---|---|---|---|---|---|---|
| Second polishing aqueous dispersion | S1 | S2 | S3 | S4 | S5 | R1 | R2 |
| **Polishing of unpatterned film** | | | | | | | |
| R$_{bt}$ (Å/min) | 70 | 80 | 60 | 20 | 180 | 200 | 950 |
| R$_{BM}$ (Ta) (Å/min) | 550 | 560 | 450 | 400 | 750 | 800 | 300 |
| R$_{BM}$ (TaN) (Å/min) | 620 | 600 | 550 | 480 | 800 | 820 | 350 |
| R$_{lb}$ (TEOS film) (Å/min) | 40 | 65 | 50 | 70 | 80 | 650 | 20 |
| R$_{lh}$ (low-dielectric-constant insulating film) (Å/min) | 15 | 30 | 40 | 20 | 80 | 320 | 20 |
| R$_{BM}$ (Ta) / R$_{lb}$ | 7.86 | 7.00 | 7.50 | 20.00 | 4.17 | 4.00 | 0.32 |
| R$_{BM}$ (TaN) / R$_{lb}$ | 8.86 | 7.50 | 9.17 | 24.00 | 4.44 | 4.10 | 0.37 |
| R$_{BM}$ (Tb) / R$_{lb}$ (TEOS film) | 13.75 | 8.62 | 9.00 | 5.71 | 9.38 | 1.23 | 10.00 |
| R$_{BM}$ (TaN) / R$_{lh}$ (TEOS film) | 15.50 | 9.23 | 11.00 | 6.86 | 10.00 | 1.26 | 11.67 |
| R$_{BM}$ (Tb) / R$_{lh}$ (low-dielectric-constant insulating film) | 36.67 | 18.67 | 11.25 | 10.00 | 9.38 | 2.50 | 10.00 |
| R$_{BM}$ (TaN) / R$_{lh}$ (low-dielectric-constant insulating film) | 41.33 | 20.00 | 13.75 | 24.00 | 10.00 | 2.56 | 11.67 |
| **State of low-dielectric-constant insulating film after polishing** | | | | | | | |
| Peeling in outer circumferential portion | None | None | None | None | None | Partially occurred | None |
| Number of scratches | 0 | 0 | 1 | 1 | 1 | 10 or more | 0 |
| **Polishing of patterned film** | | | | | | | |
| **Barrier metal = TaN** | | | | | | | |
| Second polishing time (min) | 0.68 | 0.67 | 0.83 | 0.94 | 0.50 | 0.47 | 1.25 |
| Dishing (Å) | 330 | 340 | 330 | 350 | 440 | 330 | 750 |
| Amount of insulating film polished (Å) | 20 or less | 20 or less | 20 or less | 35 | 20 or less | 120 | 20 or less |
| Number of scratches | 0 | 0 | 1 | 2 | 2 | 20 or more | 0 |
| **Barrier metal = TaN** | | | | | | | |
| Second polishing time (min) | 0.60 | 0.63 | 0.68 | 0.78 | 0.47 | 0.46 | 1.07 |
| Dishing (Å) | 320 | 330 | 300 | 360 | 430 | 320 | 1550 |
| Amount of insulating film polished (Å) | 20 or less | 20 or less | 20 or less | 20 or less | 20 or less | 110 | 20 or less |
| Number of scratches | 0 | 0 | 1 | 1 | 1 | 20 or more | 0 |

As is clear from Tables 2 and 3, it was found that occurrence of scratches on the polishing target surface can be significantly reduced by using the chemical mechanical polishing aqueous dispersion according to the first aspect of the invention as the second polishing aqueous dispersion, even if the semiconductor substrate (polishing target) having a low-dielectric-constant interlayer dielectric exhibiting low mechanical strength is polished in the second polishing step. It was also found that a sufficiently planarized and highly accurate polished surface can be obtained without the insulating film being polished to a large extent.

3.4. Example 6

3.4.1. Preparation of second polishing aqueous dispersion (kit for preparing chemical mechanical polishing aqueous dispersion according to the first aspect of the invention)

3.4.1-1. Preparation of liquid (I)

A polyethylene bottle was charged with the aqueous dispersion containing the colloidal silica particles C1 prepared in "3.1.2-1. Preparation of aqueous dispersion containing colloidal silica particles C1" in such an amount that the amount of silica was 1.06 wt% and the aqueous dispersion containing organic-inorganic composite particles prepared in "3.1.3. Preparation of aqueous dispersion containing organic-inorganic composite particles" in such an amount that the amount of organic-inorganic composite particles was 0.11 wt%. After the 0.21 wt% of benzotriazole and 0.11 wt% of maleic acid, the mixture was stirred for 15 minutes. After the addition of ion-exchanged water so that the total amount of the components was 100 wt%, the mixture was filtered through a filter having a pore diameter of 5 micrometers to obtain a liquid (I) A1 (aqueous dispersion).

3.4.1-2. Preparation of liquid (II)

Hydrogen peroxide was dissolved in ion-exchanged water so that the hydrogen peroxide concentration was 5 wt% to obtain a liquid (II) B1. 3.4.2. Evaluation of polishing performance of second polishing aqueous dispersion
100 parts by weight of the liquid (I) A1 and 638 parts by weight of the liquid (II) B1 prepared as described above were mixed to prepare a chemical mechanical polishing aqueous dispersion S6. The pH of the chemical mechanical polishing aqueous dispersion S6 was 2.3. Since the chemical mechanical polishing aqueous dispersion S6 has the same composition and pH as those of the chemical mechanical polishing aqueous dispersion S1 prepared in Example 1, the chemical mechanical polishing aqueous dispersion S6 can be considered to be the same as the chemical mechanical polishing aqueous dispersion S1 prepared in Example 1.
The polishing performance was evaluated in the same manner as in Example 1 except for using the chemical mechanical polishing aqueous dispersion S6 prepared as described above as the second polishing aqueous dispersion instead of the chemical mechanical polishing aqueous dispersion S1. The results were the same as those of Example 1.

3.5. Example 7

3.5.1. Preparation of second polishing aqueous dispersion (kit for preparing chemical mechanical polishing aqueous dispersion according to the first aspect of the invention)

3.5.1-1. Preparation of liquid (I)

A polyethylene bottle was charged with the aqueous dispersion containing the colloidal silica particles C1 prepared in "3.1.2-1. Preparation of aqueous dispersion containing colloidal silica particles C1" in such an amount that the amount of silica was 2.0 wt%, the aqueous dispersion containing organic-inorganic composite particles prepared in "3.1.3. Preparation of aqueous dispersion containing organic-inorganic composite particles" in such an amount that the amount of organic-inorganic composite particles was 0.2 wt%, and a 35 wt% hydrogen peroxide aqueous solution in such an amount that the amount of hydrogen peroxide was 0.6 wt%. The mixture was then stirred for 15 minutes. After the addition of ion-exchanged water so that the total amount of the components was 100 wt%, the mixture was filtered through a filter having a pore diameter of 5 micrometers to obtain a liquid (I) A2 (aqueous dispersion).

3.5.1-2. Preparation of liquid (II)

A polyethylene bottle was charged with 0.4 wt% of benzotriazole and 0.2 wt% of maleic acid. The mixture was stirred for 15 minutes. After the addition of ion-exchanged water so that the total amount of the components was 100 wt%, the mixture was filtered through a filter having a pore diameter of 5 micrometers to obtain a liquid (II) A3 (aqueous dispersion).

3.5.2. Evaluation of polishing performance of second polishing aqueous dispersion

50 parts by weight of the liquid (I) A2 and 50 parts by weight of the liquid (II) A3 prepared as described above were mixed to prepare a chemical mechanical polishing aqueous dispersion S7. The pH of the chemical mechanical polishing aqueous dispersion S7 was 2.3. Since the chemical mechanical polishing aqueous dispersion S7 has the same composition and pH as those of the chemical mechanical polishing aqueous dispersion S1 prepared in Example 1, the chemical mechanical polishing aqueous dispersion S7 can be considered to be the same as the chemical mechanical polishing aqueous dispersion S 1 prepared in Example 1.

The polishing performance was evaluated in the same manner as in Example 1 except for using the chemical mechanical polishing aqueous dispersion S7 prepared as described above as the second polishing aqueous dispersion instead of the chemical mechanical polishing aqueous dispersion S1. The results were the same as those of Example 1.

3.6. Example 8

3.6.1. Preparation of second polishing aqueous dispersion (kit for preparing chemical mechanical polishing aqueous dispersion according to the first aspect of the invention)

3.6.1-1. Preparation of liquid (I)

A polyethylene bottle was charged with the aqueous dispersion containing the colloidal silica particles C1 prepared in "3.1.2-1. Preparation of aqueous dispersion containing colloidal silica particles C1" in such an amount that the amount of silica was 2.13 wt% and the aqueous dispersion containing organic-inorganic composite particles prepared in "3.1.3. Preparation of aqueous dispersion containing organic-inorganic composite particles" in such an amount that the amount of organic-inorganic composite particles was 0.21 wt%. The mixture was then stirred for 15 minutes. After the addition of ion-exchanged water so that the total amount of the components was 100 wt%, the mixture was filtered through a filter having a pore diameter of 5 micrometers to obtain a liquid (I) A4 (aqueous dispersion).

3.6.1-2. Preparation of liquid (II)

A polyethylene bottle was charged with 0.43 wt% of benzotriazole and 0.21 wt% of maleic acid. The mixture was then stirred for 15 minutes. After the addition of ion-exchanged water so that the total amount of the components was 100 wt%, the mixture was filtered through a filter having a pore diameter of 5 micrometers to obtain a liquid (II) A5 (aqueous dispersion).

3.6.2. Evaluation of polishing performance of second polishing aqueous dispersion

50 parts by weight of the liquid (I) A4, 50 parts by weight of the liquid (II) A5, 6.38 parts by weight of the liquid (III) B 1 prepared as described above were mixed to prepare a chemical mechanical polishing aqueous dispersion S8. The pH of the chemical mechanical polishing aqueous dispersion S8 was 2.3. Since the chemical mechanical polishing aqueous dispersion S8 has the same composition and pH as those of the chemical mechanical polishing aqueous dispersion S 1 prepared in Example 1, the chemical mechanical polishing aqueous dispersion S8 can be considered to be the same as the chemical mechanical polishing aqueous dispersion S1 prepared in Example 1.

The polishing performance was evaluated in the same manner as in Example 1 except for using the chemical mechanical polishing aqueous dispersion S8 prepared as described above as the second polishing aqueous dispersion instead of the chemical mechanical polishing aqueous dispersion S1. The results were the same as those of Example I.

Although only some embodiments of the invention have been described in detail above, those skilled in the art will readily appreciate that many modifications are possible in the embodiments without departing from the novel teachings and advantages of this invention. Accordingly, all such modifications are intended to be included within the scope of this invention.

A chemical mechanical polishing aqueous dispersion, including: (A) inorganic particles; (B) at least one type of particles selected from the group consisting of organic particles and organic-inorganic composite particles; (C) at least one compound selected from the group consisting of quinolinecarboxylic acid, quinolinic acid, a divalent organic acid (excluding quinolinic acid), and a hydroxyl acid; (D) at least one compound selected from the group consisting of benzotriazole and benzotriazole derivatives; (E) an oxidizing agent; and (F) water, the chemical mechanical polishing aqueous dispersion containing the component (A) in an amount of 0.05 to 2.0 wt% and the component (B) in an amount of 0.005 to 1.5 wt%, having a ratio ($W_A/W_B$) of the amount ($W_A$) of the component (A) to the amount ($W_B$) of the component (B) of 0.1 to 200, and having a pH of 1.0 to 5.0.

**Claims**

1.  A chemical mechanical polishing aqueous dispersion, comprising:

    (A) inorganic particles;
    (B) at least one type of particles selected from the group consisting of organic particles and organic-inorganic composite particles;
    (C) at least one compound selected from the group consisting of quinolinecarboxylic acid, quinolinic acid, a divalent organic acid (excluding quinolinic acid), and a hydroxyl acid;
    (D) at least one compound selected from the group consisting of benzotriazole and benzotriazole derivatives;
    (E) an oxidizing agent; and
    (F) water,
    the chemical mechanical polishing aqueous dispersion containing the component (A) in an amount of 0.05 to 2.0 wt% and the component (B) in an amount of 0.005 to 1.5 wt% and the component (E) in an amount of 0.05 to 0.5 wt%, having a ratio (WA/WB) of the amount (WA) of the component (A) to the amount (WB) of the component (B) of 0.1 to 200, and having a pH of 1.0 to 5.0.

2.  The chemical mechanical polishing aqueous dispersion as defined in claim 1, containing the component (C) in an amount of 0.005 to 3.0 wt%.

3.  The chemical mechanical polishing aqueous dispersion as defined in claim 1 or 2, wherein the component (A) is silica particles.

4.  The chemical mechanical polishing aqueous dispersion as defined in any one of claims 1 to 3, wherein the component (D) is benzotriazole and is contained in the chemical mechanical polishing aqueous dispersion in an amount of 0.01 to 5.0 wt%.

5.  A kit for preparing the chemical mechanical polishing aqueous dispersion as defined in any one of claims 1 to 4 by mixing a liquid (I) and a liquid (II),
    the liquid (I) being an aqueous dispersion including: the inorganic particles (A); at least one type of particles (B) selected from the group consisting of organic particles and organic-inorganic composite particles; at least one compound (C) selected from the group consisting of quinolinecarboxylic acid, quinolinic acid, a divalent organic acid (excluding quinolinic acid), and a hydroxyl acid; at least one compound (D) selected from the group consisting of benzotriazole and benzotriazole derivatives; and the water (F); and
    the liquid (II) including the oxidizing agent (E) and the water (F).

6.  A kit for preparing the chemical mechanical polishing aqueous dispersion as defined in any one of claims 1 to 4 by mixing a liquid (I) and a liquid (II),
    the liquid (I) being an aqueous dispersion including: the inorganic particles (A); at least one type of particles (B) selected from the group consisting of organic particles and organic-inorganic composite particles; and the water (F); and
    the liquid (II) including: at least one compound (C) selected from the group consisting of quinolinecarboxylic acid, quinolinic acid, a divalent organic acid (excluding quinolinic acid), and a hydroxyl acid; and the water (F).

7.  A kit for preparing the chemical mechanical polishing aqueous dispersion as defined in any one of claims 1 to 4 by mixing a liquid (I), a liquid (II) and a liquid (III),
    the liquid (I) being an aqueous dispersion including: the inorganic particles (A); at least one type of particles (B) selected from the group consisting of organic particles and organic-inorganic composite particles; and the water (F);
    the liquid (II) including: at least one compound (C) selected from the group consisting of quinolinecarboxylic acid, quinolinic acid, a divalent organic acid (excluding quinolinic acid), and a hydroxyl acid; and the water (F); and
    the liquid (III) including the oxidizing agent (E) and the water (F).

8.  The kit as defined in claim 6 or 7, wherein the liquid (I) further includes at least one component selected from: at least one compound (C) selected from the group consisting of quinolinecarboxylic acid, quinolinic acid, a divalent organic acid (excluding quinolinic acid), and a hydroxyl acid; at least one compound (D) selected from the group consisting of benzotriazole and benzotriazole derivatives; and the oxidizing agent (E).

9.  The kit as defined in any one of claims 6 to 8, wherein the liquid (II) further includes at least one component selected from: the inorganic particles (A); at least one type of particles (B) selected from the group consisting of organic particles and organic-inorganic composite particles; at least one compound (D) selected from the group consisting of benzotriazole and benzotriazole derivatives; and the oxidizing agent (E).

**10.** A chemical mechanical polishing method, comprising:

chemically and mechanically polishing a polishing target by using a chemical mechanical polishing aqueous dispersion having, when chemically and mechanically polishing a copper film, a barrier metal film, and an insulating film under identical conditions, a ratio "RCu/RBM" of a polishing rate RCu of the copper film to a polishing rate RBM of the barrier metal film of 50 or more and a ratio "RCu/RIn" of the polishing rate RCu of the copper film to a polishing rate RIn of the insulating film of 50 or more; and
chemically and mechanically polishing the polishing target by using the chemical mechanical polishing aqueous dispersion as defined in any one of claims 1 to 4.

**Patentansprüche**

**1.** Wässrige chemisch-mechanische Polierdispersion, die umfasst:

(A) anorganische Teilchen;
(B) zumindest eine Art von Teilchen, ausgewählt aus der Gruppe bestehend aus organischen Teilchen und organisch-anorganischen Verbundteilchen;
(C) zumindest eine Verbindung, ausgewählt aus der Gruppe bestehend aus Chinolincarbonsäure, Chinolinsäure, einer zweiwertigen organischen Säure (ausgenommen Chinolinsäure), und einer Hydroxylsäure;
(D) zumindest eine Verbindung, ausgewählt aus der Gruppe bestehend aus Benzotriazol und Benzotriazol-Derivaten;
(E) ein Oxidationsmittel; und
(F) Wasser,
die chemisch-mechanische Polierdispersion enthaltend die Komponente (A) in einer Menge von 0,05 bis 2,0 Gew.-% und die Komponente (B) ein einer Menge von 0,005 bis 1,5 Gew.-% und die Komponente (E) in einer Menge von 0,05 bis 0,5 Gew.-%, mit einem Verhältnis (WA/WB) der Menge (WA) der Komponente (A) zu der Menge (WB) der Komponente (B) von 0,1 bis 200, und mit einem pH von 1,0 bis 5,0.

**2.** Wässrige chemisch-mechanische Polierdispersion nach Anspruch 1, enthaltend die Komponente (C) in einer Menge von 0,005 bis 3,0 Gew.-%.

**3.** Wässrige chemisch-mechanische Polierdispersion nach Anspruch 1 oder 2, wobei die Komponente (A) Siliziumoxidteilchen darstellt.

**4.** Wässrige chemisch-mechanische Polierdispersion nach einem der Ansprüche 1 bis 3, wobei die Komponente (D) Benzotriazol ist und in der wässrigen chemisch-mechanischen Polierdispersion in einer Menge von 0,01 bis 5,0 Gew.-% enthalten ist.

**5.** Bausatz zur Anfertigung der wässrigen chemisch-mechanischen Polierdispersion nach einem der Ansprüche 1 bis 4 durch Mischen einer Flüssigkeit (I) und einer Flüssigkeit (II),
die Flüssigkeit (I) ist eine wässrige Dispersion, die einschließt: die anorganischen Teilchen (A); zumindest eine Art von Teilchen (B), ausgewählt aus der Gruppe bestehend aus organischen Teilchen und organisch-anorganischen Verbundteilchen; zumindest eine Verbindung (C), ausgewählt aus der Gruppe bestehend aus Chinolincarbonsäure, Chinolinsäure, einer zweiwertigen organischen Säure (ausgenommen Chinolinsäure), und einer Hydroxylsäure; zumindest eine Verbindung (D), ausgewählt aus der Gruppe bestehend aus Benzotriazol und Benzotriazol-Derivaten; und das Wasser (F); und
die Flüssigkeit (II) schließt das Oxidationsmittel (E) und das Wasser (F) ein.

**6.** Bausatz zur Anfertigung der wässrigen chemisch-mechanischen Polierdispersion nach einem der Ansprüche 1 bis 4 durch Mischen einer Flüssigkeit (I) und einer Flüssigkeit (II),
die Flüssigkeit (I) ist eine wässrige Dispersion, die einschließt: die anorganischen Teilchen (A); zumindest eine Art von Teilchen (B), ausgewählt aus der Gruppe bestehend aus organischen Teilchen und organisch-anorganischen Verbundteilchen; und das Wasser (F); und

die Flüssigkeit (II) schließt ein: zumindest eine Verbindung (C), ausgewählt aus der Gruppe bestehend aus Chinolincarbonsäure, Chinolinsäure, einer zweiwertigen organischen Säure (ausgenommen Chinolinsäure), und einer Hydroxylsäure; und das Wasser (F).

7. Bausatz zur Anfertigung der wässrigen chemisch-mechanischen Polierdispersion nach einem der Ansprüche 1 bis 4 durch Mischen einer Flüssigkeit (I), einer Flüssigkeit (II) und einer Flüssigkeit (III), die Flüssigkeit (I) ist eine wässrige Dispersion, die einschließt: die anorganischen Teilchen (A); zumindest eine Art von Teilchen (B), ausgewählt aus der Gruppe bestehend aus organischen Teilchen und organisch-anorganischen Verbundteilchen; und das Wasser (F); die Flüssigkeit (II) schließt ein: zumindest eine Verbindung (C), ausgewählt aus der Gruppe bestehend aus Chinolincarbonsäure, Chinolinsäure, einer zweiwertigen organischen Säure (ausgenommen Chinolinsäure), und einer Hydroxylsäure; und das Wasser (F); und die Flüssigkeit (III) schließt das Oxidationsmittel (E) und das Wasser (F) ein.

8. Bausatz nach Anspruch 6 oder 7, wobei die Flüssigkeit (I) ferner zumindest eine Komponente einschließt, ausgewählt aus: zumindest einer Verbindung (C), ausgewählt aus der Gruppe bestehend aus Chinolincarbonsäure, Chinolinsäure, einer zweiwertigen organischen Säure (ausgenommen Chinolinsäure), und einer Hydroxylsäure; zumindest einer Verbindung (D), ausgewählt aus der Gruppe bestehend aus Benzotriazol und Benzotriazol-Derivaten; und dem Oxidationsmittel (E).

9. Bausatz nach einem der Ansprüche 6 bis 8, wobei die Flüssigkeit (II) ferner zumindest eine Komponente einschließt, ausgewählt aus: den anorganischen Teilchen (A); zumindest einer Art von Teilchen (B), ausgewählt aus der Gruppe bestehend aus organischen Teilchen und organisch-anorganischen Verbundteilchen; zumindest einer Verbindung (D), ausgewählt aus der Gruppe bestehend aus Benzotriazol und Benzotriazol-Derivaten; und dem Oxidationsmittel (E).

10. Chemisch-mechanisches Polierverfahren, welches aufweist:

chemisches und mechanisches Polieren eines zu polierenden Materials unter Verwendung einer wässrigen chemisch-mechanischen Polierdispersion, das, wenn ein Kupferfilm, ein Barrieremetall-Film, und ein isolierender Film unter identischen Bedingungen chemisch und mechanisch poliert werden, ein Verhältnis "RCu/RBM" einer Polierrate RCu des Kupferfilms zu einer Polierrate RBM des Barrieremetall-Films von 50 oder mehr und ein Verhältnis "RCu/RIn" der Polierrate RCu des Kupferfilms zu einer Polierrate RIn des isolierenden Films von 50 oder mehr aufweist; und

chemisches und mechanisches Polieren des zu polierenden Materials unter Verwendung der wässrigen chemisch-mechanischen Polierdispersion nach einem der Ansprüche 1 bis 4.

**Revendications**

1. Dispersion aqueuse de polissage chimico-mécanique, comprenant :

(A) des particules inorganiques ;
(B) au moins un type de particules choisies parmi le groupe consistant en des particules organiques et des particules composites organiques-inorganiques ;
(C) au moins un composé choisi parmi le groupe consistant en l'acide quinolinecarboxylique, l'acide quinolinique, un acide organique divalent (à l'exclusion de l'acide quinolinique), et un acide hydroxylé ;
(D) au moins un composé choisi parmi le groupe consistant en le benzotriazole et des dérivés du benzotriazole ;
(E) un agent oxydant ; et
(F) de l'eau,
la dispersion aqueuse de polissage chimico-mécanique contenant le composant (A) dans une quantité de 0,05 à 2,0% en poids et le composant (B) dans une quantité de 0,005 à 1,5% en poids et le composant (E) dans une quantité de 0,05 à 0,5% en poids, ayant un rapport (WA/WB) de la quantité (WA) du composant (A) sur la quantité (WB) du composant (B) de 0,1 à 200, et ayant un pH de 1,0 à 5,0.

2. Dispersion aqueuse de polissage chimico-mécanique selon la revendication 1, contenant le composant (C) dans une quantité de 0,005 à 3,0% en poids.

**3.** Dispersion aqueuse de polissage chimico-mécanique selon la revendication 1 ou 2, dans lequel le composant (A) est des particules de silice.

**4.** Dispersion aqueuse de polissage chimico-mécanique selon l'une quelconque des revendications 1 à 3, dans lequel le composant (D) est le benzotriazole et est contenu dans la dispersion aqueuse de polissage chimico-mécanique dans une quantité de 0,01 à 5,0% en poids.

**5.** Kit de préparation de la dispersion aqueuse de polissage chimico-mécanique selon l'une quelconque des revendications 1 à 4 en mélangeant un liquide (I) et un liquide (II),
le liquide (I) étant une dispersion aqueuse incluant : les particules inorganiques (A) ; au moins un type de particules (B) choisies parmi le groupe consistant en des particules organiques et des particules composites organiques-inorganiques ; au moins un composé (C) choisi parmi le groupe consistant en l'acide quinolinecarboxylique, l'acide quinolinique, un acide organique divalent (à l'exclusion de l'acide quinolinique), et un acide hydroxylé ; au moins un composé (D) choisi parmi le groupe consistant en le benzotriazole et des dérivés du benzotriazole ; et l'eau (F) ; et
le liquide (II) incluant l'agent oxydant (E) et l'eau (F).

**6.** Kit de préparation de la dispersion aqueuse de polissage chimico-mécanique selon l'une quelconque des revendications 1 à 4 en mélangeant un liquide (I) et un liquide (II),
le liquide (I) étant une dispersion aqueuse incluant : les particules inorganiques (A) ; au moins un type de particules (B) choisies parmi le groupe consistant en des particules organiques et des particules composites organiques-inorganiques ; et l'eau (F) ; et
le liquide (II) incluant : au moins un composé (C) choisi parmi le groupe consistant en l'acide quinolinecarboxylique, l'acide quinolinique, un acide organique divalent (à l'exclusion de l'acide quinolinique), et un acide hydroxylé ; et l'eau (F).

**7.** Kit de préparation de la dispersion aqueuse de polissage chimico-mécanique selon l'une quelconque des revendications 1 à 4 en mélangeant un liquide (I), un liquide (II) et un liquide (III),
le liquide (I) étant une dispersion aqueuse incluant : les particules inorganiques (A) ; au moins un type de particules (B) choisies parmi le groupe consistant en des particules organiques et des particules composites organiques-inorganiques ; et l'eau (F) ;
le liquide (II) incluant : au moins un composé (C) choisi parmi le groupe consistant en l'acide quinolinecarboxylique, l'acide quinolinique, un acide organique divalent (à l'exclusion de l'acide quinolinique), et un acide hydroxylé ; et l'eau (F) ; et
le liquide (III) incluant l'agent oxydant (E) et l'eau (F).

**8.** Kit selon la revendication 6 ou 7, dans lequel le liquide (I) inclut en outre au moins un composant choisi parmi : au moins un composé (C) choisi parmi le groupe consistant en l'acide quinolinecarboxylique, l'acide quinolinique, un acide organique divalent (à l'exclusion de l'acide quinolinique), et un acide hydroxylé ; au moins un composé (D) choisi parmi le groupe consistant en le benzotriazole et des dérivés du benzotriazole ; et l'agent oxydant (E).

**9.** Kit selon l'une quelconque des revendications 6 à 8, dans lequel le liquide (II) inclut en outre au moins un composant choisi parmi : les particules inorganiques (A) ; au moins un type de particules (B) choisies parmi le groupe consistant en des particules organiques et des particules composites organiques-inorganiques ; au moins un composé (D) choisi parmi le groupe consistant en le benzotriazole et des dérivés du benzotriazole ; et l'agent oxydant (E).

**10.** Procédé de polissage chimico-mécanique, comprenant :

polir chimiquement et mécaniquement une cible de polissage en utilisant une dispersion aqueuse de polissage chimico-mécanique ayant, lors du polissage chimique et mécanique d'un film de cuivre, d'un film métallique barrière, et d'un film d'isolation sous des conditions identiques, un rapport « RCu/RBM » d'un rapport de polissage RCu du film de cuivre sur un rapport de polissage RBM du film métallique barrière de 50 ou plus et un rapport « RCu/RIn » du rapport de polissage RCu du film de cuivre sur un rapport de polissage RIn du film d'isolation de 50 ou plus ; et
polir chimiquement et mécaniquement la cible de polissage en utilisant la dispersion aqueuse de polissage chimico-mécanique selon l'une quelconque des revendications 1 à 4.

FIG. 1A

FIG. 1B

FIG. 1C

FIG. 2A

FIG. 2B

FIG. 2C

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001196336 A